# EUROPEAN PATENT SPECIFICATION

(11) **EP 3 067 938 B1**
(45) Date of publication and mention of the grant of the patent: **06.05.2020**
(21) Application number: 16153318.7
(22) Date of filing: 29.01.2016
(51) Int. Cl.: H01L 31/054, H02S 20/32, G01S 3/78, G05D 3/00

(54) **METHOD AND APPARATUS FOR CALIBRATING A MICRO-CONCENTRATOR SOLAR ARRAY**
VERFAHREN UND VORRICHTUNG ZUR KALIBRIERUNG EINER MIKROKONZENTRATOR-SOLARANLAGE
PROCÉDÉ ET APPAREIL D'ÉTALONNAGE D'UN RÉSEAU DE PANNEAUX SOLAIRES À MICROCONCENTRATEUR

(30) Priority: 12.03.2015 US 201514656259
(43) Date of publication of application: 14.09.2016
(73) Proprietor: The Boeing Company, Chicago, IL 60606-1596 (US)
(72) Inventor: SINGER, Scott Benjamin, CHICAGO, IL, 60606-2016 (US); KRUT, Dimitri D., CHICAGO, IL, 60606-2016 (US); KARAM, Nasser H., CHICAGO, IL, 60606-2016 (US)
(74) Representative: Plasseraud IP

(56) References cited:
- WO-A1-2009/126263
- WO-A2-2008/115305
- DE-A1-102008 039 692
- DE-A1-102009 039 499
- DE-A1-102011 109 190
- US-A1- 2012 266 938

## Description

### BACKGROUND INFORMATION

### 1. Field:

The disclosed system and method relate to a micro-concentrator solar array and, more particularly, to a method and apparatus for dynamically setting a selected threshold for the electrical output generated by the solar cells in a solar array.

### 2. Background:

Electric power generation from solar or photovoltaic cells has experienced significant interest recently. Solar cells convert light energy, typically from the sun, into electrical energy. The light intensity on a solar cell may be referred to as the number of suns, where a 1-sun concentration corresponds to standard illumination at 1 kW/m2.

Widespread adoption of solar cells for power generation may require further breakthrough in both cost and efficiency. For example, many solar power generators currently available employ flat-plate technologies, where the solar cells operate under 1-sun concentration. These types of solar power generators have relatively low solar-to-power conversion efficiencies, are relatively large and cumbersome, and tend to transform a majority of light energy into heat. Moreover, these solar power generators may result in relatively long charge times in practice. Specifically, sometimes charging equipment using the solar power generator may take many hours, even over several days. In addition to the long charge times, the position of the solar power generators needs to be adjusted periodically during the day in order to accommodate the changing position of the sun in the sky. Therefore, it would be desirable to have a method and apparatus that take into account at least some of the issues discussed above, as well as other possible issues.

WO 2008/115305 A2 discloses an automated tracking solar power collector, the tracking solar powered collector includes at least one solar collector such as a solar concentrator and an actuator coupled to the at least one solar collector. The tracking solar power collector further includes a tracking controller configured to aim the at least one solar collector toward the sun with the actuator; and, a power controller configured to supply power to the actuator based on an energy collected by the at least one solar collector.

US 2012/266938 A1 discloses a system and method for tracking a position of the Sun, and includes a solar tracker controller that generates directional control signals responsive to sensing signals. A solar tracking algorithm controls operation of the solar tracker controller responsive to the sensing signals. The solar tracking algorithm includes a rough tracking mode of operation for causing a pointing axis of at least one solar receiver to point generally in a direction of the Sun as indicated by the sensing signals. A searching mode of operation positions the at least one solar receiver such that sunlight falls on at least one solar cell of the receiver. A fine tracking mode of operation positions a pointing axis of the at least one solar receiver responsive to the feedback signal from the at least one solar receiver.

### SUMMARY

In one aspect, an apparatus is defined by independent claim 1.

In another aspect, a solar array is defined by independent claim 10.

In yet another aspect, a method is provided and defined by independent claim 12.

The features and functions can be achieved independently in various aspects of the present disclosure or may be combined in yet other aspects in which further details can be seen with reference to the following description and drawings.

### BRIEF DESCRIPTION OF THE DRAWINGS

The novel features believed characteristic of the illustrative examples are set forth in the appended claims. The illustrative examples, however, as well as a preferred mode of use, further objectives and advantages thereof, will best be understood by reference to the following detailed description of an illustrative examples of the present disclosure when read in conjunction with the accompanying drawings, wherein:
**Figure 1** is an illustration of the disclosed micro-concentrator solar array including a plurality of solar cells arranged on a coverglass and a plurality of micro-electromechanical systems (MEMS) based reflectors arranged on a substrate;
**Figure 2** is a cross-section of the micro-concentrator solar array taken along section line **2-2** in **Figure 1****;**
**Figure** 3 is a perspective view of a portion of the coverglass shown in **Figure 1****,** where receivers may be used to mount the solar cells to the coverglass;
**Figure** 4 is an exemplary process flow diagram illustrating a method of adjusting the reflectors shown in **Figure 1****;**
**Figure 5** is an illustration of an alternative aspect of the micro-concentrator solar array;
**Figure 6** is an illustration of a solar array system in the form of a block diagram in accordance with an illustrative example;
**Figure 7** is an illustration of a calibration system in the form of a block diagram in accordance with an illustrative example;
**Figure 8** is an illustration of a solar array in accordance with an illustrative example;
**Figure 9** is an illustration of a solar array system in accordance with an illustrative example;
**Figure 10** is an illustration of a cross-sectional view of a solar array in accordance with an illustrative example;
**Figure 11** is an illustration of a solar array having a threshold solar cell in accordance with an illustrative example;
**Figure 12** is an illustration of a solar array having a threshold solar cell in accordance with an illustrative example;
**Figure 13** is an illustration of a graph of an electrical output corresponding to a changing position of a light source in accordance with an illustrative example;
**Figure 14** is an illustration of a solar array in accordance with an illustrative example;
**Figure 15** is an illustration of a calibration system in accordance with an illustrative example;
**Figure 16** is an illustration of a calibration circuit in accordance with an illustrative example;
**Figure 17** is an illustration of a process for focusing light onto a plurality of solar cells in the form of a flowchart in accordance with an illustrative example;
**Figure 18** is an illustration of a process for focusing light onto a solar cell in the form of a flowchart in accordance with an illustrative example;
**Figure 19** is an illustration of a process for tracking sunlight using a solar array in the form of a flowchart in accordance with an illustrative example;
**Figure 20** is an illustration of a process for managing a solar array in the form of a flowchart in accordance with an illustrative example;
**Figure 21** is an illustration of a process for computing a selected threshold for a solar array in the form of a flowchart in accordance with an illustrative example;
**Figure 22** is an illustration of a process for calibrating a reflector in the form of a flowchart in accordance with an illustrative example; and
**Figures 23A** and **23B** are illustrations of a process for managing the reflectors in a solar array in the form of a flowchart in accordance with an illustrative example.

### DETAILED DESCRIPTION

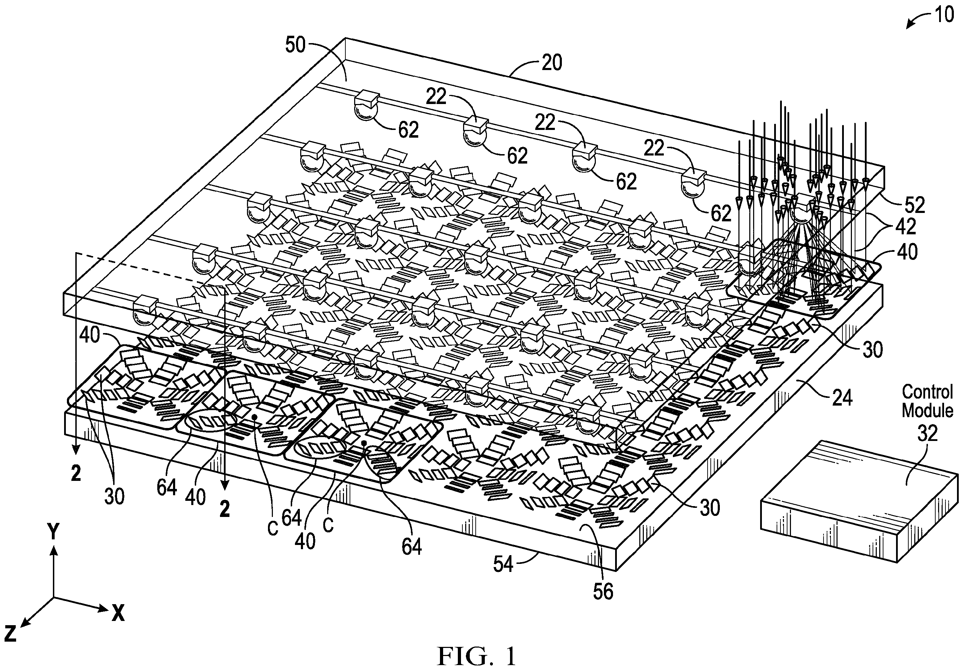

As shown in **Figure 1**, the micro-concentrator solar array **10** according to an aspect of the disclosure may include a coverglass **20,** a plurality of solar cells **22,** a substrate **24,** a plurality of micro-electromechanical systems (MEMS) based mirrors or reflectors **30,** and a control module **32.** In the exemplary aspect as shown, the solar cells **22** may be arranged in a 5x5 array upon the coverglass **20,** which results in a total of twenty-five solar cells **22** included within the micro-concentrator solar array **10.** However, those skilled in the art will appreciate that the micro-concentrator solar array **10** may include any number of solar cells **22.** An array **40** of reflectors **30** may be associated with each solar cell **22.** Each reflector **30** included within the array **40** may be positioned relative to the associated solar cell **22** in order to focus or reflect a plurality of light beams **42** generated by a light source (not illustrated) onto the solar cell **22.**

The light source may be any type of radiating energy source such as, for example, man-made lighting in a building, or the sun. Each reflector **30** may be selectively tiltable such that if the position of the light source changes, each reflector **30** located within the associated array **40** may be tilted accordingly in order to track the changed position of the light source relative to the associated solar cell **22.** For example, if the light source is the sun, then each reflector **30** located within the associated array **40** may be tilted accordingly in order to track the changing position of the sun throughout the day. The tilting of the reflectors **30** relative to the light source is described in greater detailed below.

The micro-concentrator solar array **10** may be used in any application where light energy, typically from the sun, may be converted into electrical energy. For example, **Figure 1** illustrates a single micro-concentrator solar array **10** for purposes of convenience and clarity. The single micro-concentrator solar array **10** in **Figure 1** may be used in relatively compact applications such as, for example, a slim-line pocket-sized portable power generator. However, the single micro-concentrator solar array **10** may be electrically connected or ganged with other micro-concentrator solar arrays in order to create a two-dimensional or tiled array of multiple micro-concentrator arrays (not illustrated). The two-dimensional array of multiple micro-concentrator arrays may be used in relatively large-scale applications such as, for example, a terrestrial portable power generator, an unmanned aerial vehicle (UAV), or a satellite.

The coverglass **20** may be constructed of any transparent material that allows for the light beams **42** to pass through such as, for example, glass, plastic, or silicon dioxide. The substrate **24** may be used to support or mount the reflectors **30.** In one non-limiting aspect, the substrate **24** may be constructed of fused silica.

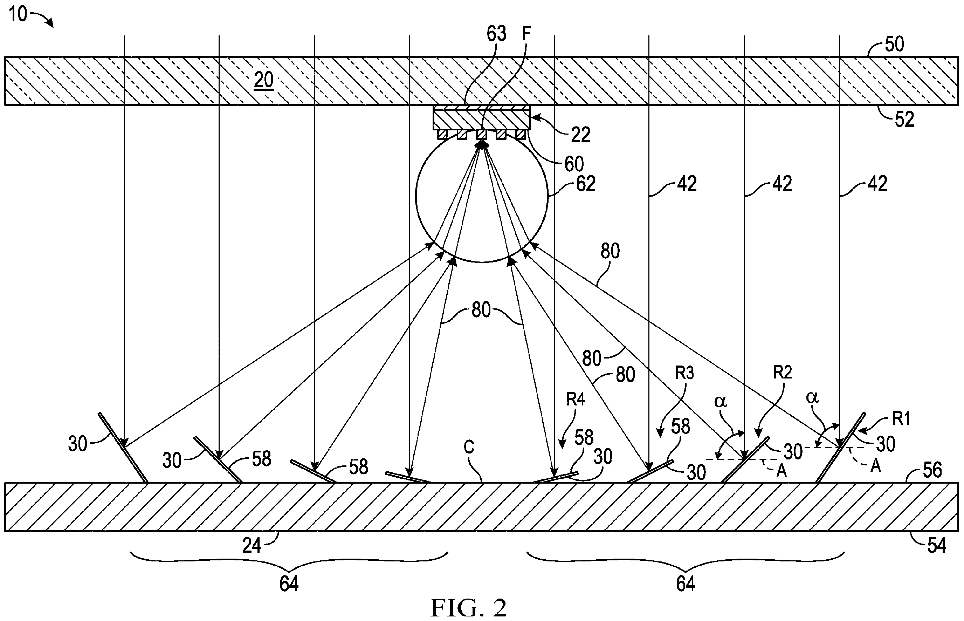

**Figure 2** is a cross-section of a portion of the coverglass **20,** a single solar cell **22,** the substrate **24,** and the reflectors **30** associated with the single solar cell **22,** taken along section line **2-2** in **Figure 1****.** Referring generally to **Figures 1-2****,** the coverglass **20** may include an outer surface **50** and an inner surface **52,** and the substrate **24** may also include an outer surface **54** and an inner surface **56.** In one aspect, an optional anti-reflection coating may be applied to the inner and outer surfaces **52, 50,** of the coverglass **20.** The inner surface **52** of the coverglass **20** generally opposes the inner surface **56** of the substrate **24.** Each solar cell **22** may include a front surface **60** and a back surface **63** (seen in **Figure 2****).** The back surface **63** of the solar cell **22** may be affixed to or carried by the inner surface **52** of the coverglass **20.**

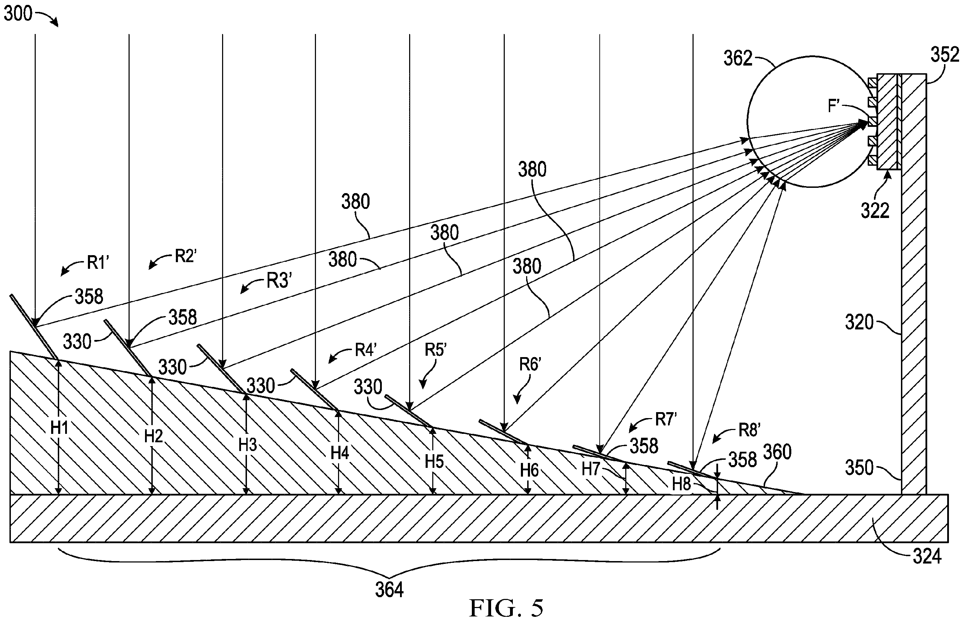

Although **Figures 1-2** show the coverglass **20** located above the substrate **24,** it is to be understood that this illustration is merely exemplary in nature. Those skilled in the art will appreciate that the coverglass **20** may be located relative to the substrate **24** in any position where the light beams **42** may be directed upon the reflectors **30** and onto the solar cells **22.** For example, in another aspect, the micro-concentrator solar array **10** may be rotated by ninety degrees, and the coverglass **20** may be located to the right of the substrate **24.** Moreover, in some aspects the coverglass **20** may be omitted. Instead, the solar cells **22** may be mounted on a corresponding support member **320** shown in **Figure 5****,** and is described in greater detail below.

Referring to **Figure 1****,** in one aspect, the reflectors **30** may be arranged in a two-dimensional pattern upon the inner surface **56** of the substrate **24.** Specifically, each array **40** may include multiple sub-arrays **64** of reflectors **30.** In the aspect as shown in **Figure 1****,** each sub-array **64** may include four reflectors **30,** however, it is to be understood that any number of reflectors **30** may be included within the sub-array **64** as well. In the non-limiting aspect as shown in **Figure 1****,** each sub-array **64** of reflectors **30** may be arranged in a radially outward direction with respect to a central point C of the array **40.** The specific solar cell **22** associated with the array **40** may be positioned along the inner surface **52** of the coverglass **20** to generally oppose the central point C. Although **Figure** 1 illustrates each sub-array **64** of reflectors **30** arranged in a radially outward direction, those skilled in the art will appreciate that this illustration is merely exemplary in nature. For example, in another aspect, the reflectors **30** may be arranged in a rectangular pattern.

The solar cells **22** may also be referred to as photovoltaic cells. The solar cells **22** may be any device configured to convert solar radiation into electrical energy. In one exemplary aspect, the micro-concentrator solar array **10** may include a secondary optical device **62** associated with each solar cell **22.** However, it is to be understood that the secondary optical device **62** may be omitted in some aspects. Referring to **Figure 2****,** the secondary optical device **62** may be positioned along the front surface **60** of the solar cell **22.** The secondary optical device **62** may be used to focus the light beams **42** reflected off of each reflection surface **58** of the reflectors **30** and onto a focal point F located on the solar cell **22.** Thus, the solar cell **22** may receive an increased amount of light energy if the secondary optical device **62** is included. The secondary optical device **62** may be any type of concentrator or lens for focusing light from the reflectors **30** onto the focal point F of the solar cell **22** such as, for example, a concave lens, a convex lens, a parabolic lens, or a Fresnel lens.

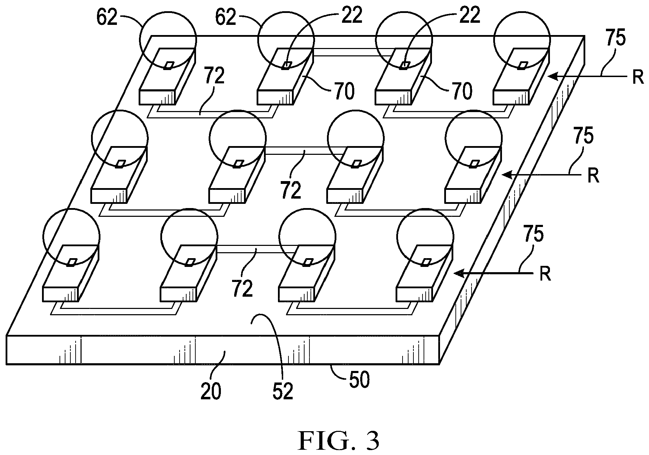

**Figure 3** illustrates a portion of the inner surface **52** of the coverglass **20,** where the coverglass **20** has been rotated one hundred and eighty degrees such that the inner surface **52** of the coverglass **20** is facing upwardly. In the aspect as shown in **Figure 3****,** the solar cells **22** are each mounted to and electrically connected to a corresponding receiver **70.** Each receiver **70** may be mounted to the inner surface **52** of the coverglass **20.** The receivers **70** may be used as an alternative approach for mounting the solar cells **22** to the coverglass **20.** In one aspect, the receivers **70** may include a heat sink or other device (not illustrated) for dissipating heat generated by the solar cell **22.**

A plurality of interconnects **72** may be used to electrically connect two or more of the receivers **70** to one another. In one aspect, the interconnects **72** may be constructed from an electrically conductive material such as, for example, metal. The interconnects **72** may be located along the inner surface **52** of the coverglass **20**, and may be used to electrically connect the receivers **70** in any number of configurations in order to provide the voltage and current required for a specific application. For example, in the aspect as shown in **Figure 3****,** the interconnects **72** may be used to connect the receivers **70** located in a single row **75** to one another in a series configuration. However, the interconnects **72** may also be used to connect each row **75** of receivers **70** to one another in a parallel configuration (the parallel connection is not illustrated in **Figure 3**). Although **Figure 3** illustrates the receivers **70** located in each row **75** connected to one another in a series configuration, it is to be understood that the receivers **70** may be connected to one another in a parallel configuration as well. Moreover, although each row **75** of receivers **70** is described as being connected to one another in a parallel configuration, it is to be understood that the rows **75** of receivers **70** may be connected together in a series configuration as well.

Referring to **Figure 2****,** the reflectors **30** may be any type of MEMS-based device having an elliptical, cylindrical, rectangular, square, or randomly shaped micro-mirror or micro-reflector configured to reflect light. An actuation device (not illustrated) may be provided for each reflector **30**. The actuation device may be used to adjust an amount of tilt of an associated reflector **30**. Specifically, as seen in **Figure 2****,** the amount of tilt of each reflector may be measured by an angle a. The angle α may be measured between the reflection surface **58** of the reflector **30** and an axis A-A. The axis A-A may be oriented generally parallel with respect to the substrate **24**. A reflected light beam **80** may represent the light reflected off of the reflection surface **58** of the reflector **30** and directed towards the secondary optical device **62**. If the secondary optical device **62** is omitted, then the reflected light beam 80 may be directed towards the focal point F located on the solar cell **22**. It should be noted that while the reflector 30 is described as being tiltable or rotatable in the x-axis direction (the x-axis is illustrated in **Figure 1**), the reflector **30** may be tilted about a second axis of rotation as well. Specifically, in one aspect, the angle α of the reflector **30** may be tilted in the z-axis direction (the z-axis is illustrated in **Figure 1**) as well. Thus, the reflector **30** may be tilted using either single-axis tracking (i.e., adjusted in either the x-axis or the z-axis) or dual-axis tracking (i.e., adjusted in both the x-axis and the z-axis). In other words, the reflectors may be tiltable or rotatable about either one axis of rotation or two axes of rotation.

The actuation device (not illustrated) may be any type of device capable of adjusting the angle α of the associated reflector **30.** For example, in one non-limiting aspect, the actuating devices may be comb-drive actuators that use static electromagnetic potential for actuation. In another aspect, the actuating devices may be a rotational actuator. One commercially available example of the rotational actuator is the 4-quadrant 2-axis actuators manufactured by Mirrorcle Technologies of Richmond, California.

Referring to both **Figures 1-2****,** the angle α of the reflectors **30** may be adjusted by applying a specific or unique amount of voltage to each of the actuation devices (not illustrated). For example, with reference to **Figure 2****,** the reflector R1 located to the far right may be tilted at a different angle α when compared to the angles α of the remaining reflectors R2, R3, and R4 located within the sub-array **64.** Each reflector **30** may be tilted at a different angle a based on the reflector's **30** position relative to the focal point F of the corresponding solar cell **22.** Thus, a unique amount of voltage may be applied to the actuation device associated with each reflector **30** in order to tilt each reflector **30** by a specific amount.

In one approach, the control module **32** may have a voltage-tilt curve stored in memory. In one aspect, the voltage-tilt curve may be stored in memory as either a lookup table or a polynomial fit to voltage-tilt data. The voltage-tilt curve may include a plurality of unique voltage values that are each associated with different values of the angle α of the reflector **30.** It should be noted that the voltage-tilt curve may be common to all of the reflectors **30** located within the micro-concentrator solar array **10.** The memory of the control module **32** may also store the position of all of the reflectors **30** relative to the corresponding solar cell **22** as well.

The control module **32** may determine the unique amount of voltage applied to each reflector **30** using the following approach. First, the control module **32** may calculate the angle α of the reflectors **30.** In the example as described, the control module **32** calculates the angle α of the reflector R1 to the far right as shown in **Figure 2****.** The control module **32** may calculate the angle α of the reflector R1 based on the position of the reflector R1 relative to the corresponding solar cell **22** (stored in memory of the control module **32),** and an angle θ of the light beams **42.** The angle θ of the light beams **42** may be measured with respect to the coverglass **20.** The angle θ of the light beams **42** may be a known value stored in memory of the control module **32.** The value of the angle θ of the light beams **42** stored in memory may be updated as the position of a light source (e.g., the sun) changes. Once the control module **32** calculates the angle α of the reflector R1, the control module **32** may then obtain the unique amount of voltage applied to the reflector R1 using the voltage tilt-curve. For example, if the control module **32** determines that the angle α of the reflector R1 should be fifteen degrees, then the control module **32** obtains the unique amount of voltage associated with an angle of fifteen degrees from the voltage-tilt curve stored in memory of the control module **32.** Finally, the control module **32** may apply the unique amount of voltage obtained from the voltage-tilt curve to the actuation device associated with the reflector R1.

Referring to **Figures 1-3****,** the control module **32** may refer to, or be part of, an application specific integrated circuit (ASIC), an electronic circuit, a combinational logic circuit, a field programmable gate array (FPGA), a processor (shared, dedicated, or group) that executes code, or a combination of some or all of the above, such as in a system-on-chip. The control module **32** may be in operative communication with each of the solar cells **22** and the reflectors **30.** Specifically, the control module **32** may be in communication with all of the solar cells **22** located within the micro-concentrator solar array **10** through the interconnects **72** located along the coverglass **20** shown in **Figure 3** (the connection between the interconnects **72** and the control module **32** is not illustrated in the figures).

The control module **32** may include control logic for monitoring the electrical output generated by all of the solar cells **22** located within the micro-concentrator solar array **10.** The electrical output measured by the control module **32** may be, for example, voltage, current, or power generated by the solar cells **22.** The control module **32** may monitor the electrical output generated by all of the solar cells **22** located within the micro-concentrator solar array **10** at a predetermined time interval. The predetermined time interval may be any set amount of time such as, for example, every thirty seconds, every minute, or every five minutes.

In the illustration as shown in **Figure 2****,** the reflectors **30** are tilted at their ideal angles α such that the reflected light beams **80** are each directed towards the focal point F located on the solar cell **22.** The control module **32** may store an ideal output value within memory. The ideal output value represents the electrical output of the solar cells **22** (e.g., voltage, current, power, etc.) when the reflectors **30** are tilted at their ideal angles. **Figure 2** illustrates the light source (e.g., the sun) directing the light beams **42** in a direction generally perpendicular to the coverglass **20** and the substrate **24.** However, as the sun moves throughout the sky throughout the day, the direction of the light beams **42** changes accordingly. Thus, the position of the reflected light beams **80** reflected off of the reflection surface **58** of each reflector **30** may also change. As a result, the reflected light beams **80** are eventually reflected away from the focal point F of the corresponding solar cell **22.** Focusing light upon the focal point F of a corresponding solar cell **22** may maximize the amount of electrical output generated by the solar cell **22.** As the reflected light beams **80** are directed away from the focal point F of the corresponding solar cell **22,** less light energy may be received by the solar cell **22.** As a result, the electrical output generated by the solar cell **22** is decreased.

Referring to **Figures 1-2****,** the control module **32** monitors the electrical output generated by all of the solar cells **22** located within the micro-concentrator solar array **10** at the predetermined time interval. The control module **32** also includes control logic for comparing the electrical output generated by the solar cells **22** with a threshold value. The threshold value may represent an electrical output generated by all of the solar cells **22** that is less than the ideal output value. For example, in one non-limiting aspect, the threshold value may be about ninety-five percent of the ideal output value.

The control module **32** may include circuitry or control logic for applying the unique amount of voltage to each of the actuation devices (not illustrated) associated with the reflectors **30** if the electrical output generated by all of the solar cells **22** is below the threshold value. Specifically, once the electrical output generated by the solar cells **22** drops below a threshold value, then the control module **32** may apply the unique amount of voltage to each of the actuation devices (not illustrated). The reflectors **30** may be re-positioned such that the reflected light beams **80** reflected off of the reflection surface **58** of each reflector **30** may be directed back towards the focal point F of the corresponding solar cell **22.** In one aspect, the control module **32** may include control logic for repositioning the reflectors **30** towards the focal point F of the corresponding solar cell **22** by first stepping through a plurality of pre-programmed reflector positions stored in memory. Each pre-programmed reflector position corresponds with a specific position of the light source. For example, if the light source is the sun, then each pre-programmed reflector position stored in memory of the control module **32** may correspond with the different positions of the sun in the sky. The control module **32** may step though the pre-programmed reflector positions until the reflectors **30** align and focus the light beams **80** towards the focal point F of the solar cell **22.**

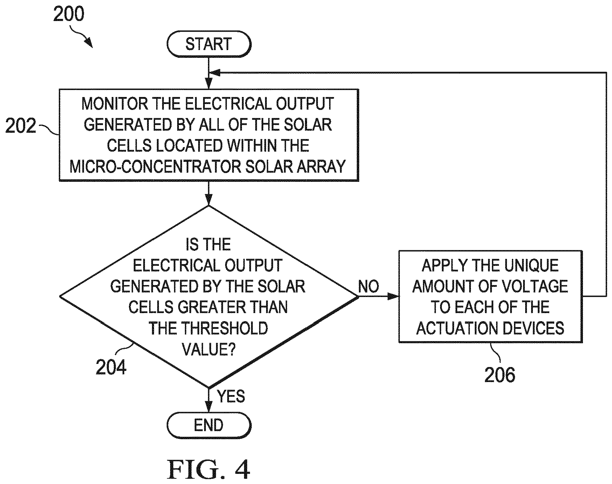

**Figure 4** is a process flow diagram illustrating an exemplary method **200** of adjusting the tilt of the reflectors **30.** Referring generally to **Figures 1-4****,** method **200** may begin at block **202,** where the control module **32** monitors the electrical output generated by all of the solar cells **22** located within the micro-concentrator solar array **10.** The electrical output measured by the control module **32** may be, for example, voltage, current, or power generated by the solar cells **22.** Method **200** may then proceed to block **204.**

In block **204,** the control module **32** compares the electrical output generated by all of the solar cells **22** located within the micro-concentrator solar array **10** with the threshold value. If the electrical output is equal to or greater than the threshold value, then method **200** may then terminate. However, if the electrical output is less than the threshold value, then method **200** may proceed to block **206.**

In block **206,** the control module **32** may apply the unique amount of voltage to each of the actuation devices (not illustrated). As discussed above, applying the unique amount of voltage to each of the actuation devices may reposition each of the reflectors **30** such that the reflected light beams **80** reflected off of the reflection surface **58** of each reflector **30** may be directed back towards the focal point F of the corresponding solar cell **22.** Method **200** may then return to block **202.**

**Figure 5** is a cross-section of an alternative aspect of a micro-concentrator solar array **300,** illustrating a single solar cell **322** and a sub-array **364** of reflectors 330 associated with the solar cell **322.** In the aspect as shown in **Figure 5****,** the reflectors **330** may be supported by a substrate **324.** A corresponding support member **320** may be attached or otherwise affixed to the substrate **324.** Specifically, the support member **320** includes a first end **350** and a second end **352.** The first end **350** of the support member **320** may be affixed to the substrate **324.** The solar cell **322** may be affixed to the second end **352** of the support member **320.** It should be noted that the aspect as shown in **Figure 5** does not require a coverglass, and instead the support member **320** may be used to carry the solar cell **322.** Although **Figure 5** illustrates a single solar cell **322,** those skilled in the art will appreciate that the solar cell **322** may be part of an array of multiple solar cells. For example, the substrate **324** may include multiple support members **320.** Each support member **320** may carry a solar cell **322.** Also, while **Figure** 5 illustrates a single sub-array **364** of the reflectors **330**, it is to be understood that multiple sub-arrays **364** of reflectors **330** may surround the solar cell **322.**

The substrate **324** may include a ramped or inclined inner surface **360.** The reflectors **330** may be positioned along the inner surface **360** of the substrate **324.** In the non-limiting aspect as shown, the sub-array **364** includes eight reflectors R1'-R8', where the reflector R1' may be the reflector **330** located the furthest away from the solar cell **322,** and the reflector R8' may be the reflector **330** located closest to the solar cell **322.** The inner surface **360** of the substrate **324** may be angled such that the reflector R1' may be positioned at a vertical height H1, the reflector R2' may be positioned at a vertical height H2, and the remaining reflectors R3'-R8' may be positioned accordingly.

The vertical heights H1-H8 of the reflectors R1'-R8' may be graduated accordingly such that light reflected off of one of the reflectors **330** in the sub-array **364** does not generally interfere with another reflector **330** located downstream. For example, the vertical height HI of the reflector R1' is greater than the vertical heights of the remaining reflectors R2'-R8'. Thus, the reflector R1' may be elevated such that a beam of light **380** reflected off a reflection surface **358** of the reflector R1' does not interfere or intersect with any of the remaining reflectors R2'-R8' located within the sub-array **364.** Instead, the beam of light **380** reflected off the reflection surface **358** may be directed towards a secondary optical device **362** and onto a focal point F' located on the solar cell **322.**

Referring generally to **Figures 1-5****,** the disclosed micro-concentrator solar array **10** provides a relatively compact and efficient approach for converting light into electrical energy. In particular, the disclosed micro-concentrator solar array **10** provides an approach for adjusting the MEMS based reflectors (e.g., the reflectors **30** shown in **Figures 1-3** or the reflectors **330** shown in **Figure 5**) based on the position of a moving light source (not illustrated). For example, if the light source is the sun, the reflectors may track the position of the sun throughout the sky. The reflectors may then reflect the light from the sun onto the focal point of a corresponding solar cell. Therefore, if the micro-concentrator solar array **10** is part of a solar power generator, then a user does not generally need to re-position the solar power generator periodically during the day in order to accommodate the changing position of the sun within the sky. Moreover, many solar power generators currently available employ flat-plate technologies, where the solar cells operate under 1-sun concentration. In contrast, the disclosed micro-concentrator solar array **10** uses the reflectors in order to concentrate light onto the solar cells. In one aspect, the disclosed solar cells may operate between about 5-suns to about 500-suns concentration. Thus, the disclosed micro-concentrator solar array **10** may employ smaller solar cells that require less space. The disclosed micro-concentrator solar array **10** may also provide higher solar-to-power conversion efficiencies, and transform less of light energy into heat when compared to the technologies currently available. While the forms of apparatus and methods herein described constitute preferred aspects of this invention, it is to be understood that the invention is not limited to these precise forms of apparatus and methods, and the changes may be made therein without departing from the scope of the invention.

The illustrative examples recognize and take into account that it may be desirable to have a method and apparatus for controlling a solar array to ensure that the highest concentrations of light are focused onto the solar cells of the solar array at substantially all times. In particular, it may be desirable to have a method and apparatus for ensuring that the solar cells of a solar array generate an electrical output that is at least at a selected threshold or threshold value.

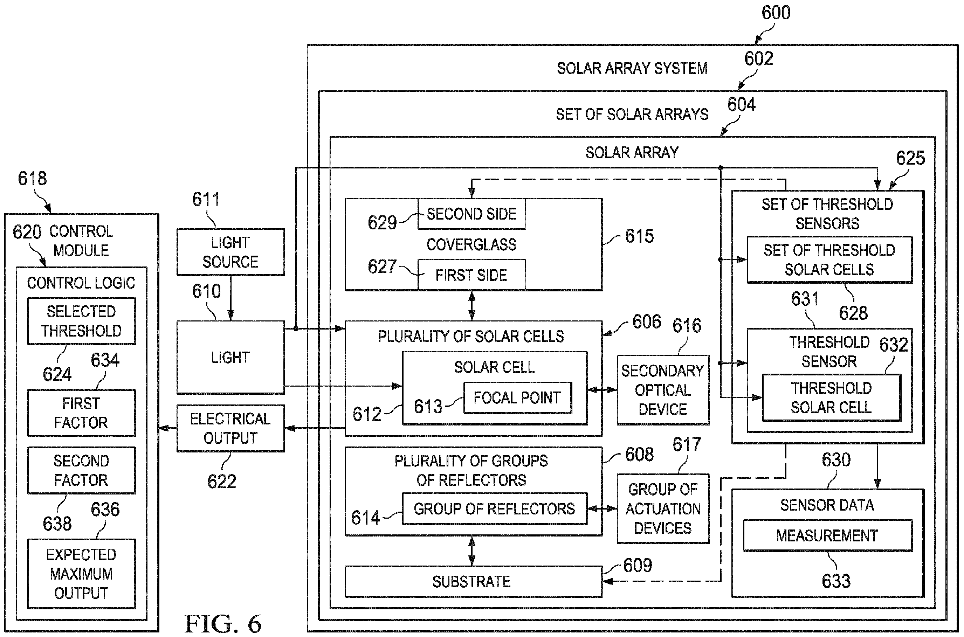

Referring now to **Figure 6****,** an illustration of a solar array system is depicted in the form of a block diagram in accordance with an illustrative example. In this illustrative example, solar array system **600** is depicted. Solar array system **600** may be comprised of set of solar arrays **602**. As used herein, a "set of" items may include one or more items.

In some illustrative examples, each of set of solar arrays **602** may be referred to as a micro-concentrator solar array. In other illustrative examples, each of set of solar arrays **602** may be referred to as a solar panel. In these cases, solar array system **600** may be referred to as a solar panel system. For example, solar array **604** may be an example of one of set of solar arrays **602.** Solar array **604** may be referred to as a micro-concentrator solar array. Micro-concentrator solar array **10** in **Figure 1** may be an example of one implementation for solar array **604.**

As depicted, solar array **604** may be comprised of plurality of solar cells **606** and plurality of groups of reflectors **608.** Plurality of groups of reflectors **608** may be supported by substrate **609.** In some illustrative examples, control electronics may be integrated into substrate **609** for controlling plurality of groups of reflectors **608.** These control electronics may be used to control actuation devices associated with the reflectors in plurality of groups of reflectors **608.**

As used herein, when one component is "associated" with another component, the association is a physical association in the depicted examples. For example, a first component, such as an actuation device, may be considered to be associated with a second component, such as a reflector, by being secured to the second component, bonded to the second component, mounted to the second component, welded to the second component, fastened to the second component, and/or connected to the second component in some other suitable manner. The first component also may be connected to the second component using a third component. Further, the first component may be considered to be associated with the second component by being formed as part of and/or as an extension of the second component.

As used herein, the phrase "at least one of," when used with a list of items, means different combinations of one or more of the listed items may be used and only one of the items in the list may be needed. The item may be a particular object, thing, or category. In other words, "at least one of" means any combination of items or number of items may be used from the list, but not all of the items in the list may be required.

For example, "at least one of item A, item B, and item C" may mean item A; item A and item B; item B; item A, item B, and item C; or item B and item C. In some cases, "at least one of item A, item B, and item C" may mean, for example, without limitation, two of item A, one of item B, and ten of item C; four of item B and seven of item C; or some other suitable combination.

Each group of reflectors in plurality of groups of reflectors **608** may correspond to one of plurality of solar cells **606.** In particular, each of the plurality of groups of reflectors **608** may correspond to one of plurality of solar cells **606** by being positioned relative to the corresponding solar cell such that the group of reflectors is capable of reflecting light **610** towards the corresponding solar cell.

Light **610** may take the form of, for example, without limitation, a beam of light that is comprised of a plurality of rays of light. Light **610** may be natural sunlight, artificial sunlight, or some other type of light. In these illustrative examples, light **610** may originate from light source **611.** Light source **611** may take the form of the sun, an artificial light source, a lamp, or some other type of lighting device or source of light or energy.

Solar cell **612** may be an example of one of plurality of solar cells **606.** Solar cell **612** may have focal point **613.** Group of reflectors **614** in plurality of groups of reflectors **608** may correspond to solar cell **612.** Group of reflectors **614** may include more than one reflector. Each reflector in group of reflectors **614** may be selectively tiltable about at least one axis such that light **610** may be reflected onto focal point **613** of solar cell **612.** Light **610** may pass through coverglass **615** and be reflected off group of reflectors **614** to be focused onto solar cell **612.** In particular, light **610** may be focused onto focal point **613** of solar cell **612** by group of reflectors **614.**

Solar cell **612** may be associated with coverglass **615.** In one illustrative example, solar cell **612** may be mounted onto coverglass **615.** For example, solar cell **612** may be mounted onto coverglass **615** using an interconnect that is associated with coverglass **615.** Solar cell **612** may be attached to the interconnect in an inverted manner, depending on the implementation. The interconnect may be, for example, a metal interconnect. Any number of interconnects may be present on coverglass **615** for holding plurality of solar cells **606.** For example, a plurality of interconnects may be used for mounting and holding plurality of solar cells **606** on coverglass **615.** In some illustrative examples, bypass diodes may be integrated onto the one or more interconnects on coverglass **615.**

In one illustrative example, each reflector in group of reflectors **614** and each reflector in plurality of groups of reflectors **608** may be implemented using a micro-electromechanical systems (MEMS) based reflector. Each reflector may be, for example, a micro-mirror that is tiltable about at least one axis. Group of actuation devices **617** may be associated with group of reflectors **614.** Each actuation device in group of actuation devices **617** may be controlled by a voltage. This voltage may also be referred to as an actuation voltage. In some cases, the particular actuation device corresponding to a reflector may be considered part of the overall reflector. In this manner, the reflector may include the structure with the reflective material capable of reflecting light **610,** the actuation device, and in some cases, one or more other components. The structure with the reflective material may be a mirror structure.

In some cases, secondary optical device **616** may be associated with solar cell **612.** For example, secondary optical device **616** may be mounted onto solar cell **612** such that light **610** may be reflected from group of reflectors **614** through secondary optical device **616** to solar cell **612.** Secondary optical device **62** in **Figures 1-2** may be an example of one implementation for secondary optical device **616.** In some cases, secondary optical device **616** may be considered optional.

Control module **618** may be in communication with solar array system **600.** In particular, control module **618** may be in communication with each of set of solar arrays **602.** For example, control module **618** may be in communication with plurality of solar cells **606** and plurality of groups of reflectors **608** of solar array **604.** Control module **618** may be used to control the positioning of each reflector in set of solar arrays **602** such that light **610** may be reflected onto each of the solar cells in set of solar arrays **602.**

Control module **618** may be considered part of the control electronics integrated into substrate **609** or separate from these control electronics. In some cases, control module **618** may be implemented in a manner similar to control module **32** in **Figure 1****.** Using control module **618,** the control electronics in substrate **609,** or a combination of the two, plurality of groups of reflectors **608** may be controlled to achieve high concentrations of light being reflected onto plurality of solar cells **606.**

In one illustrative example, control module **618** may monitor electrical output **622** generated by plurality of solar cells **606** in solar array **604.** Electrical output **622** may be in the form of voltage, current, power, or some other type of electrical output. Control module **618** may include control logic **620.** Control logic **620** may be used to determine when electrical output **622** is below selected threshold **624.** Selected threshold **624** may be selected based on experimentation. Selected threshold **624** may also be referred to as a threshold value.

Selected threshold **624** may be a value or level for electrical output **622.** For example, when electrical output **622** takes the form of current, which may also be referred to as electrical current, selected threshold **624** is a level or value of current that may be measured in amperes, milliamperes, or some other unit of current . When electrical output **622** takes the form of voltage, selected threshold **624** is a voltage level that may be measured in volts, millivolts, or some other unit of voltage. Further, when electrical output **622** takes the form of power, selected threshold **624** is a power level that may be measured in joules per second, watts, or some other unit of electrical power.

In one illustrative example, selected threshold **624** may be computed using control logic **620** in control module **618** based on light **610** from light source **611.** Light **610** may take the form of ambient light that is available in the area or environment around solar array **604.** Selected threshold **624** may be dynamically modified to take into account changes in light **610** that are available for detection by solar array **604** over time. For example, without limitation, light **610** available for detection by solar array **604** may be reduced due to a number of conditions that include, but are not limited to, weather conditions, cloud coverage, foliage, aerial vehicles, other types of obstructions, or some combination thereof.

In some illustrative examples, set of threshold sensors **625** may be used to monitor light **610.** Set of threshold sensors **625** may include one or more sensors that measure light **610** to generate sensor data **630.** Depending on the implementation, set of threshold sensors **625** may include at least one of a solar cell, a photodiode, or some other type of light sensor. As one illustrative example, set of threshold sensors **625** may take the form of set of threshold solar cells **628.**

Sensor data **630** may include any number of measurements generated over time. These measurements may take the form of intensity measurements, electrical current measurements, voltage measurements, power measurements, or some other type of measurement.

In one illustrative example, sensor data **630** includes intensity measurements generated over time. These intensity measurements may take the form of, for example, light intensity-related values in units of lumens, candelas, lux, or some other unit for measuring light intensity. Depending on the implementation, sensor data **630** may include measurements of any parameter that may correlated with the intensity of light **610**. For example, without limitation, sensor data **630** may include measurements of intensity, current, voltage, resistance, power, some other type of parameter, or some combination thereof. In some cases, these types of measurements may then be converted into intensity measurements by set of threshold sensors **625** or control module **618**.

As one illustrative example, sensor data **630** generated by set of threshold solar cells **628** may take the form of intensity data comprising one or more intensity measurements of light **610**. Each of these intensity measurements in sensor data **630** may be the average of the intensity readings generated by set of threshold solar cells **628** for light **610**.

In another illustrative example, set of threshold sensors **625** may be implemented as a single threshold sensor **631.** Threshold sensor **631** may take the form of, for example, without limitation, threshold solar cell **632** that generates any number of intensity measurements over time to form sensor data **630**.

Depending on the implementation, one or more of set of threshold sensors **625** may be mounted to coverglass **615**. For example, coverglass **615** may have first side **627** that faces plurality of groups of reflectors **608** and second side **629** that faces light source **611**. In one illustrative example, plurality of solar cells **606** may be mounted to first side **627** of coverglass **615**, while one or more of set of threshold sensors **625** may be mounted to second side **629** of coverglass **615.** For example, without limitation, when light source **611** takes the form of the sun, threshold solar cell **632** may be mounted to second side **629** of coverglass **615** such that threshold solar cell **632** faces upwards towards the sun.

In another illustrative example, one or more of set of threshold sensors **625** may be mounted to and supported by substrate **609.** For example, when light source **611** takes the form of the sun, threshold solar cell **632** may be mounted upwards-facing to substrate **609** such that threshold solar cell **632** faces the sun.

In other illustrative examples, one or more of set of threshold sensors **625** may be mounted to some other component of solar array **604** or some other component physically associated with solar array **604.** In yet other illustrative examples, one or more of set of threshold sensors **625** may be mounted on a device separate from but located proximately relative to solar array **604.** Each of set of threshold sensors **625** may be positioned with respect to the various components of the solar array to ensure that a desired amount of light reaches set of threshold sensors **625** based on the position of light source **611.** In some cases, the position of solar array **604** relative to the ground, the orientation of solar array **604** relative to the ground, the position of light source **611** relative to the ground or solar array **604,** the orientation of light source **611** relative to the ground or solar array **604,** or some combination thereof may be used to determine the placement of each of set of threshold sensors **625.**

As one illustrative example, when solar array **604** is oriented substantially parallel to the ground, threshold solar cell **632** may be mounted to coverglass **615** to ensure that the amount of light that reaches threshold solar cell 632 will most directly correlate with the amount of light that reaches plurality of solar cells **606.** In another example, solar array **604** may be tilted. Consequently, threshold solar cell **632** may be mounted at or near the end of substrate **609** that is positioned nearest light source **611.** In some illustrative examples, threshold solar cell **632** may be removably mounted to coverglass **615,** substrate **609,** or some other component of or associated with solar array **604** such that threshold solar cell **632** may be mounted to different locations relative to solar array **604** to achieve different configurations tailored for different positions of light source **611** or different types of light source **611.**

Control module **618** may receive sensor data **630** and use sensor data **630** to compute selected threshold **624.** Control module **618** may use any number of factors, scaling factors, equations, algorithms, mathematical formulas, or combination thereof to compute selected threshold **624** based on sensor data **630.**

As one illustrative example, measurement **633** in sensor data **630** may take the form of an electrical current measurement, a voltage measurement, a power measurement, or some other type of measurement. Control module **618** may multiply measurement **633** in sensor data **630** by first factor **634.**

First factor **634,** which may be *n,* is a scale factor selected to account for the relative difference in size and configuration between set of threshold sensors **625** and plurality of solar cells **606.** First factor **634** may be defined as a decimal number, a fraction, or a percentage, depending on the implementation.

Multiplying first factor **634** by measurement **633** may produce expected maximum output **636,** which may be *Pₘₐₓ.* Depending on whether measurement **633** is an electrical current measurement, a voltage measurement, or a power measurement, expected maximum output **636** will be an electrical current value, a voltage value, or a power value, respectively. Expected maximum output **636** may be the maximum electrical output **622** expected to be generated by plurality of solar cells **606** when plurality of groups of reflectors **608** are positioned to reflect the highest concentrations of light **610** onto plurality of solar cells **606.** When plurality of groups of reflectors **608** are positioned to reflect the highest concentrations of light **610** onto plurality of solar cells **606,** plurality of groups of reflectors **608** may be considered to be in a "best focus" state.

Multiplying expected maximum output **636** by second factor **638** produces selected threshold **624.** Depending on whether expected maximum output **636** is an electrical current value, a voltage value, or a power value, selected threshold **624** will be an electrical current value threshold, a voltage value threshold, or a power value threshold, respectively, for electrical output **622.**

Second factor **638,** which may be f, may be a preselected scale factor. Second factor **638** may be defined as a decimal number, a fraction, or a percentage, depending on the implementation. In one illustrative example, second factor **638** may be about 0.99. In this manner, selected threshold **624** may be set to about 99 percent of expected maximum output **636.** In another illustrative example, second factor **638** may be selected as a factor between about 0.80 and about 0.99. In still other illustrative examples, second factor **638** may be selected as a factor between about 0.70 and about 0.99.

When measurement **633** takes the form of an intensity measurement, control module **618** may use other factors or some other type of computational process to compute selected threshold **624** for electrical output **622.** In one illustrative example, the units of the intensity measurement may be converted into units for an electrical quantity, such as current, voltage, or power, prior to multiplication by first factor **634** and second factor **638.**

When electrical output **622** is below selected threshold **624,** control logic **620** may reposition plurality of groups of reflectors **608.** Repositioning plurality of groups of reflectors **608** may include repositioning at least one reflector in plurality of groups of reflectors **608** by tilting the at least one reflector about at least one axis. This repositioning may be implemented, for example, by adjusting the voltage applied to the actuation device corresponding to the at least one reflector. Thus, control module **618** may control the repositioning of at least one reflector in plurality of groups of reflectors **608** with respect to at least one axis when electrical output **622** is below selected threshold **624.**

In this manner, control module **618** having control logic **620** may be used to improve the performance of solar array **604** such that electrical output **622** produced by solar array **604** is sufficiently high. For example, as the direction in which light **610** encounters solar array **604** changes over time, any number of reflectors in plurality of groups of reflectors **608** may need to be repositioned, or tilted differently, to maintain at least selected threshold **624** of electrical output **622** from solar array **604.**

The direction in which light **610** encounters solar array **604** may change for a number of different reasons. For example, the location of solar array **604** relative to light source **611** from which light **610** originates may be changed, the position(s) or location(s) of light source **611** may change relative to the solar array **604,** or some combination thereof.

In one illustrative example, control module **618** may be used to control each of plurality of groups of reflectors **608** in each solar array in set of solar arrays **602** in a similar manner to improve the performance of each of set of solar arrays **602** in solar array system **600.** By controlling the positioning of each group of reflectors in plurality of groups of reflectors **608** based on electrical output **622,** control module **618** having control logic **620** may ensure that the highest concentrations of light **610** are focused onto plurality of solar cells **606.**

This type of positioning control may allow control module **618** having control logic **620** to dynamically track light source **611** as the relative positioning between solar array **604** and light source **611** changes over time. For example, without limitation, control module **618** having control logic **620** may control the positioning of each reflector in group of reflectors **614** based on electrical output **622.** In this manner, control module **618** may ensure that the high concentrations of reflected light focused onto solar cell **612** by group of reflectors **614** are maintained when the position of light source **611** changes relative to solar array **604.**

In some illustrative examples, control module **618** may perform dynamic tracking of light source **611** when solar array **604** is in a dynamic tracking mode. In one illustrative example, solar array **604** may be configured to automatically enter the dynamic tracking mode when turned on or when receiving power. In other illustrative examples, control module **618** may be configured to control when solar array **604** enters the dynamic tracking mode and leaves the dynamic tracking mode.

The illustrative examples recognize and take into account that it may be desirable to calibrate solar array **604** just prior to solar array **604** entering the dynamic tracking mode or upon solar array **604** entering the dynamic tracking mode. In some cases, this calibration may be referred to as an initialization of the reflectors in solar array **604.** The illustrative examples also recognize and take into account that it may be desirable to recalibrate solar array **604** when solar array **604** loses focus on light source **611.** Solar array **604** may lose track of light source **611** for a number of different reasons, including but not limited to, light source **611** moving to a location where light **610** does not reach solar array **604,** solar array **604** being moved to a location where solar array **604** no longer receives light **610** from light source **611**, the dimming of light **610** from light source **611**, turning off power to light source **611**, or some other suitable reason.

When solar array **604** loses track of light source **611** such that electrical output **622** is below some minimum output value, it may be desirable to recalibrate solar array **604.** For example, solar array **604** may be considered as losing track of light source **611** when the current, voltage, or power output of solar array **604** is substantially zero or below some minimum current level, voltage level, or power level, respectively. In this illustrative example, when solar array **604** loses track of light source **611,** each reflector in plurality of groups of reflectors **608** may be moved into a default position. The default position for a reflector may be, for example, without limitation, a position in which reflector is substantially parallel to a plane through solar array **604.** This plane may be, for example, the plane of substrate **609.**

The illustrative examples recognize and take into account that prior to reinitiating the dynamic tracking of light source **611,** it may be desirable to move the reflectors in plurality of groups of reflectors **608** from the default position into a calibrated position. This type of calibration may reduce the overall amount of time needed to regain focus on light source **611.** In other words, this type of calibration may reduce the overall amount of time needed for solar array **604** to re-find light source **611** such that electrical output **622** at least reaches selected threshold **624.** Further, this type of calibration may improve the accuracy and efficiency with which light source **611** is tracked. Consequently, performing this type of calibration may improve the overall performance of solar array **604.**

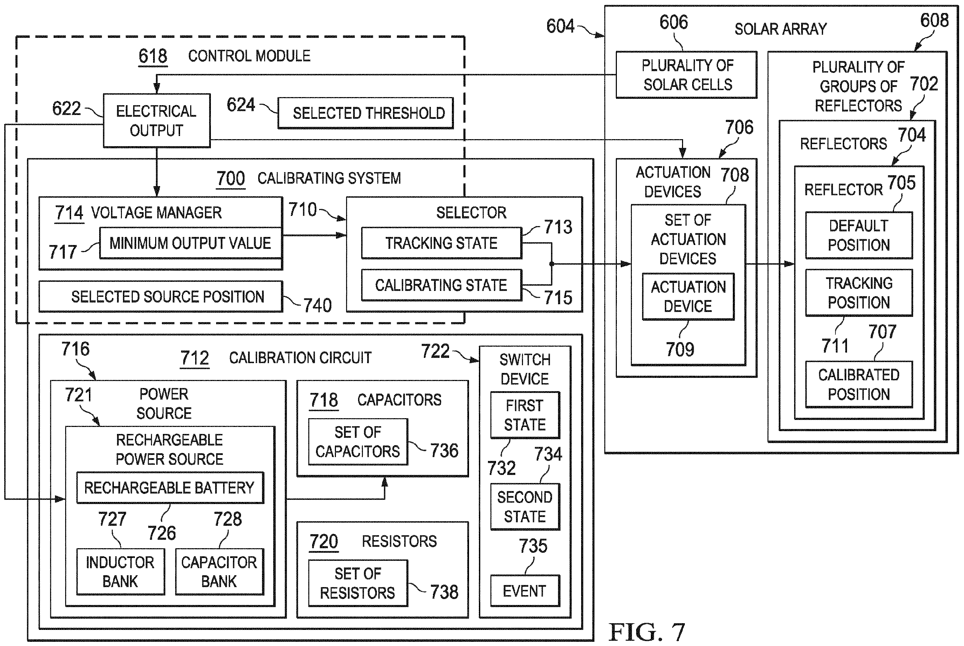

With reference now to **Figure 7****,** an illustration of a calibration system is depicted in the form of a block diagram in accordance with an illustrative example. Calibration system **700** may be used to calibrate a plurality of reflectors **702** included in plurality of groups of reflectors **608** using a plurality of actuation devices **706.** One or more of actuation devices **706** may be associated with each of reflectors **702.** Reflectors **702** may include some or all of the reflectors in plurality of groups of reflectors **608,** depending on the implementation.

Calibration system **700** is used to move reflectors **702** from default positions into calibrated positions. Reflector **704** is an example of one of reflectors **702** in plurality of groups of reflectors **608** that may be calibrated using calibration system **700.** As depicted, set of actuation devices **708** may be associated with reflector **704.** In particular, set of actuation devices **708** includes one or more actuation devices that are used to move reflector **704** with respect to at least one axis. For example, without limitation, set of actuation devices **708** may be used to tilt reflector **704** with respect to at least one axis. Actuation device **709** is an example of one of set of actuation devices **708.**

At least a portion of electrical output **622** generated by plurality of solar cells **606** may be used to power actuation devices **708.** For example, voltage manager **714** may send at least a portion of electrical output **622** to actuation devices **708** to apply voltages to actuation devices **708.** Voltage manager **714** may be implemented using hardware, software, firmware, or both.

The voltage that is applied to each of set of actuation devices **708** associated with reflector **704** determines the position of reflector **704** at a given point in time. In one illustrative example, actuation device **709** is used to tilt reflector **704** about a selected axis. In this example, increasing the voltage applied to actuation device **709** increases the degree of tilt about the selected axis, while decreasing the voltage applied to actuation device **709** decreases the degree of tilt about the selected axis.

Calibrating reflector **704** means moving reflector **704** from default position **705** into calibrated position **707.** In default position **705,** reflector **704** may be, for example, without limitation, positioned substantially parallel to a plane through solar array **604** in **Figure 6****.** This plane may be, for example, the plane of substrate **609.** Calibrated position **707** may be offset from default position **705** in some manner. For example, calibrated position **707** may be rotationally offset from default position **705** with respect to at least one axis. In one illustrative example, reflector **704** is tilted with respect to at least one axis in calibrated position **707** relative to default position **705.**

In this illustrative example, calibration system **700** includes selector **710** and calibration circuit **712.** Selector **710** may be considered part of, partially part of, or independent of control module **618,** depending on the implementation. In some cases, voltage manager **714** may also be considered part of calibration system **700.** In this manner, calibration system **700** may include at least a portion of control module **618.**

Selector **710** determines whether voltage manager **714** or calibration circuit **712** is used to power actuation devices **708.** In one illustrative example, selector **710** may be implemented in the form of a switch device. The switch device may take the form of, for example, but is not limited to, a single pole, double throw (SPDT) switch. Selector **710** may be controlled by voltage manager **714** in this illustrative example.

Selector **710** may be operable to move between tracking state **713** and calibrating state **715.** When selector **710** is in tracking state **713,** selector **710** electrically connects voltage manager **714** to actuation devices **708** such that voltage manager **714** supplies power to actuation devices **708.** Moving selector **710** from tracking state **713** to calibrating state **715** electrically disconnects voltage manager **714** from actuation devices **708** and electrically connects calibration circuit **712** to actuation devices **708.** Conversely, moving selector **710** from calibrating state **715** to tracking state **713** electrically disconnects calibration circuit **712** actuation devices **708,** while electrically connecting voltage manager **714** to actuation devices **708.**

While selector **710** is in tracking state **713**, solar array **604** may lose focus on light source **611** described in **Figure 6****.** Consequently, electrical output **622** generated by plurality of solar cells **606** may drop. Voltage manager **714** controls selector **710** to switch from tracking state **713** to calibrating state **715** when voltage manager **714** determines that electrical output **622** or at least the portion of electrical output **622** being used to power actuation devices **708** drops below minimum output value **717.** Minimum output value **717** may be a minimum preselected value of electrical current, voltage, or power. In some cases, minimum output value **717** may be substantially zero.

In one illustrative example, the switching of selector **710** from tracking state **713** to calibrating state **715** causes reflectors **702** to move into their default positions because power is no longer being supplied to actuation devices **706.** Reflectors **702** may remain in these default positions until they are recalibrated by calibration circuit **712.**

In calibrating state **715,** selector **710** electrically connects calibration circuit **712** to actuation devices **708.** In one illustrative example, calibration circuit **712** includes power source **716,** a plurality of capacitors **718,** a plurality of resistors **720,** and switch device **722.** Power source **716** is used to charge capacitors **718** over time. Resistors **720** are used to control the charging rate and discharging rate of capacitors **718.**

Power source **716** may take a number of different forms. In this illustrative example, power source **716** takes the form of rechargeable power source **721.** Rechargeable power source **721** may include rechargeable battery **726,** capacitor bank **728,** inductor bank **727,** some other type of rechargeable source of electrical power, or some combination thereof.

Switch device **722** may be implemented using, for example, without limitation, an open-close switch. In some illustrative examples, switch device **722** may be comprised of a plurality of switch members. Each of these switch members may take the form of an open-close switch or some other type of switching mechanism.

Switch device **722** may switch between first state **732** and second state **734.** Switch device **722** in first state **732** prevents power source **716** from charging capacitors **718.** Conversely, switch device **722** in second state **734** allows power source **716** to charge capacitors **718** when switch device **722** is in second state **734.**

When selector **710** is in calibrating state **715,** and switch device **722** is in first state **732,** any energy stored in capacitors **718** may be discharged and allowed to flow to actuation devices **708.** If capacitors **718** are fully discharged when selector **710** is in calibrating state **715,** no power is supplied to actuation devices **708.** When switch device **722** is switched from first state **732** to second state **734**, power source **716** can then charge capacitors **718.**

In some cases, switch device **722** may be manually operated to switch between first state **732** and second state **734.** For example, manually pressing a button associated with solar array **604** may cause switch device **722** to move from first state **732** to second state **734.** In another illustrative example, switch device **722** may be at least one of mechanically or electrically configured to switch between first state **732** and second state **734** without human intervention.

In one illustrative example, switch device **722** may be manually operated to switch from first state **732** to second state **734** but may be configured to switch from second state **734** to first state **732** automatically in response to event **735** occurring. Event **735** may be, for example, without limitation, a lapse of a preselected period of time or a timer, receiving an electrical signal, or some other type of event. The preselected period of time may be, for example, without limitation, between about 2 milliseconds and about 100 milliseconds, depending on the implementation. In another illustrative example, the preselected period of time may be between about 50 milliseconds and about 2 seconds.

In some illustrative examples, event **735** may be selected such that switch device **722** moves from second state **734** to first state **732** before any of capacitors **718** can be fully charged. In this manner, the creation of an open circuit by one or more fully charged capacitors may be prevented.

In one illustrative example, set of capacitors **736** and set of resistors **738** are used to control the voltage applied to set of actuation devices **708** associated with reflector **704**. For example, upon solar array **604** losing track of light source **611** as described in **Figure 6****,** selector **710** may switch from tracking state **713** to calibrating state **715,** thereby causing reflector **704** to move from a current position of reflector **704** into default position **705.** The current position of reflector **704** may be, for example, without limitation, tracking position **711.** Tracking position **711** may be the position of reflector **704** during tracking state **713.** Tracking position **711** of reflector **704** may change over time during tracking state **713.**

At some point later in time, switch device **722** may be moved from first state **732** into second state **734,** thereby allowing power source **716** to send electrical power to set of actuation devices **708** associated with reflector **704** and to charge set of capacitors **736.** Set of capacitors **736** may be charged to some predetermined level for some preselected period of time needed to apply a calibration voltage to each of set of actuation devices **708.** Applying this calibration voltage to each of set of actuation devices **708** moves reflector **704** from default position **705** to calibrated position **707.**

In response to event **735** occurring, switch device **722** moves back from second state **734** to first state **732,** halting the charging of set of capacitors **736** by power source **716.** Set of capacitors **736** begins discharging slowly. Together, set of capacitors **736** and set of resistors **738** maintain the calibration voltage applied to each of set of actuation devices **708** for at least a desired period of time.

In particular, the resistance of each of set of resistors **738** and the capacitance of each of set of capacitors **736** is selected such that a corresponding calibration voltage can be maintained at each of set of actuation devices **708.** Depending on the implementation, the calibration voltage may be the same or different for each of set of actuation devices **708.** In this manner, reflector **704** may be held in calibrated position **707** for at least the desired period of time.

This desired period of time may be used for solar array **604** to regain focus on light source **611** in **Figure 1****.** In particular, once reflectors **702** are in their calibrated positions, voltage manager **714** may monitor electrical output **622** and determine whether electrical output **622** rises above minimum output value **717** or some other preselected value for current, voltage, or power.

In other words, once reflectors **702** are in their calibrated positions, voltage manager **714** is used to determine whether electrical output **622** is sufficient to move selector **710** from calibrating state **715** to tracking state **713.** If electrical output **622** is sufficient, selector **710** is moved from calibrating state **715** to tracking state **713.** In tracking state **713,** solar array **604,** using control module **618,** may perform dynamic tracking of light source **611** as described above in **Figure 6**. By starting this dynamic tracking with reflectors **702** in their calibrated positions, the overall amount of time needed to dynamically track light source **611** in **Figure 6** may be reduced.

In some illustrative examples, the energy generated by plurality of solar cells **606** may be used to recharge rechargeable power source **721.** For example, rechargeable power source **721** may be configured to fully charge capacitors **718** many times before rechargeable power source **721** needs to be recharged. Depending on the implementation, at least a portion of electrical output **622** generated by plurality of solar cells **606** may be siphoned to recharge rechargeable power source **721.** This recharging may be set to occur anytime that solar array **604** enters the dynamic tracking mode, after some predetermined number of state switches of switch device **722,** or in response to the occurrence of some other type of event.

In this manner, calibration system **700** may improve the overall performance of solar array **604.** In particular, calibration system **700** improves the efficiency with which solar array **604** tracks light source **611** in **Figure 6****.**

Similar calibration may be performed for any other solar arrays that may be present in set of solar arrays **602** in solar array system **600** in **Figure 6**. Depending on the implementation, a single calibration system **700** may be used to calibrate each of set of solar arrays **602** in solar array system **600** in **Figure 6****.** In some cases, more than one calibration system may be used to calibrate the reflectors in solar array system **600** in **Figure 6****.**

In some illustrative examples, the calibrated positions selected for reflectors **702** may be selected based on selected source position **740** for light source **611** in **Figure 6**. Selected source position **740** may be an angular position, (Θ, φ) .

Depending on the implementation, selected source position **740** may be, but is not limited to, an expected current position, a known current position, a computed current position, an estimated position, or otherwise-determined position of light source **611** relative to solar array **604** at the time at which solar array **604** enters the dynamic tracking mode or a time just prior to solar array **604** entering the dynamic tracking mode. In one illustrative example, when light source **611** takes the form of the sun, selected source position **740** may be an initial source position for the sun, which may be expected based on, for example, without limitation, the current calendar date, current time of day, some other piece of information, or some combination thereof.

The illustrations of solar array system **600** in **Figure 6** and calibration system **700** in **Figure 7** is not meant to imply physical or architectural limitations to the manner in which an illustrative example may be implemented. Other components in addition to or in place of the ones illustrated may be used. Some components may be optional. Also, the blocks are presented to illustrate some functional components. One or more of these blocks may be combined, divided, or combined and divided into different blocks when implemented in an illustrative example.

For example, in some cases, an individual control module may be associated with each of set of solar arrays **602** instead of control module **618** controlling each of set of solar arrays **602.** In some illustrative examples, a portion of plurality of solar cells **606** may each be associated with a secondary optical device while another portion of plurality of solar cells **606** may not be associated with a secondary optical device.

In other illustrative examples, calibration circuit **712** may include other electrical components in addition to or in place of capacitors **718** and resistors **720.** For example, in some cases, calibration circuit **712** may include one or more inductors. Calibration circuit **712** may be implemented in any of a number of different ways that allow calibration circuit **712** to be electrically connected to and disconnected from actuation devices **706** and that allow the calibration voltage to be applied to each of actuation devices **706** maintained for some period of time when calibration circuit **712** is electrically connected to actuation devices **706.**

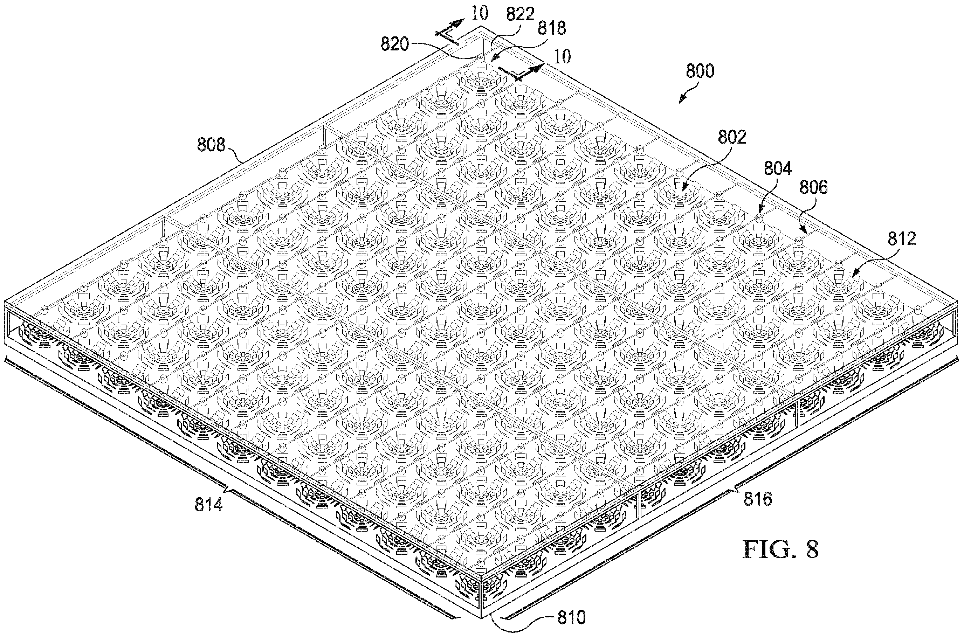

With reference now to **Figure 8****,** an illustration of a solar array is depicted in accordance with an illustrative example. In this illustrative example, solar array **800** may be an example of one implementation for solar array **604** in **Figure 6****.** As depicted, solar array **800** may include plurality of groups of reflectors **802** and plurality of solar cells **804,** which may be examples of implementations for plurality of groups of reflectors **608** and plurality of solar cells **606,** respectively, in **Figure 6****.**

As depicted, plurality of solar cells **804** are connected to plurality of interconnects **806** on coverglass **808.** Plurality of secondary optical devices **812** may be mounted onto plurality of solar cells **804.** In particular, each of plurality of secondary optical devices **812** may be mounted onto a corresponding one of plurality of solar cells **804.**

Plurality of groups of reflectors **802** are supported by substrate **810.** Plurality of groups of reflectors **802** are arranged in rows **814** and columns **816.** Plurality of groups of reflectors **802** may form a 12 by 12 array in this illustrative example.

Group of reflectors **818** may be an example of one of plurality of groups of reflectors **802.** Solar cell **820** may correspond to group of reflectors **818.** Solar cell **820** may be connected to interconnect **822** of plurality of interconnects **806.** Group of reflectors **818** may be configured to reflect a beam of light to focus the reflected beam of light onto solar cell **820.**

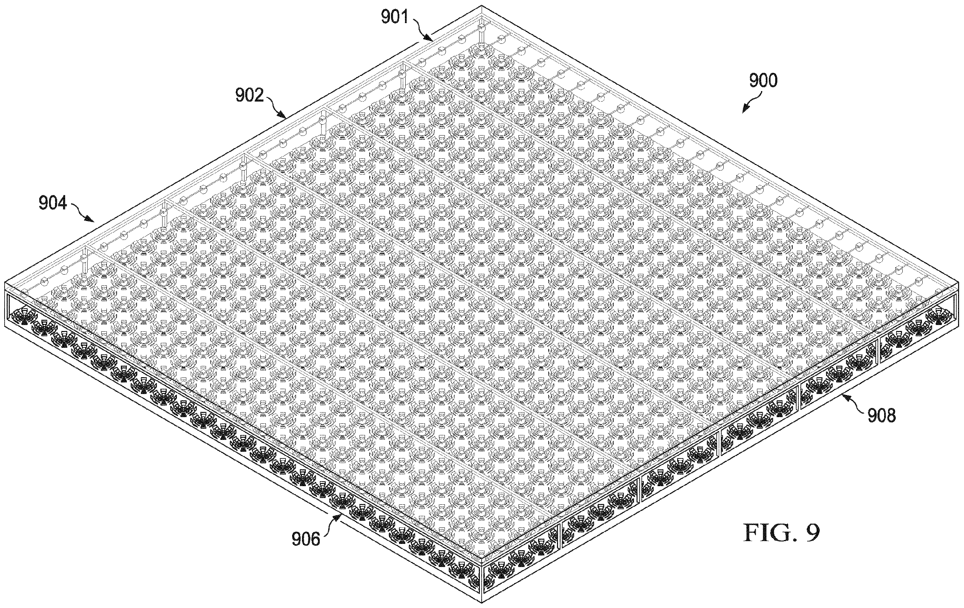

With reference now to **Figure 9****,** an illustration of a solar array system is depicted in accordance with an illustrative example. In this illustrative example, solar array system **900** may be an example of one implementation for solar array system **600** in **Figure 6****.** Solar array system **900** may include set of solar arrays **901.** Set of solar arrays **901** includes solar arrays **902, 904, 906,** and **908.** Each of set of solar arrays **901** may be implemented in a manner similar to solar array **800** in **Figure 8****.**

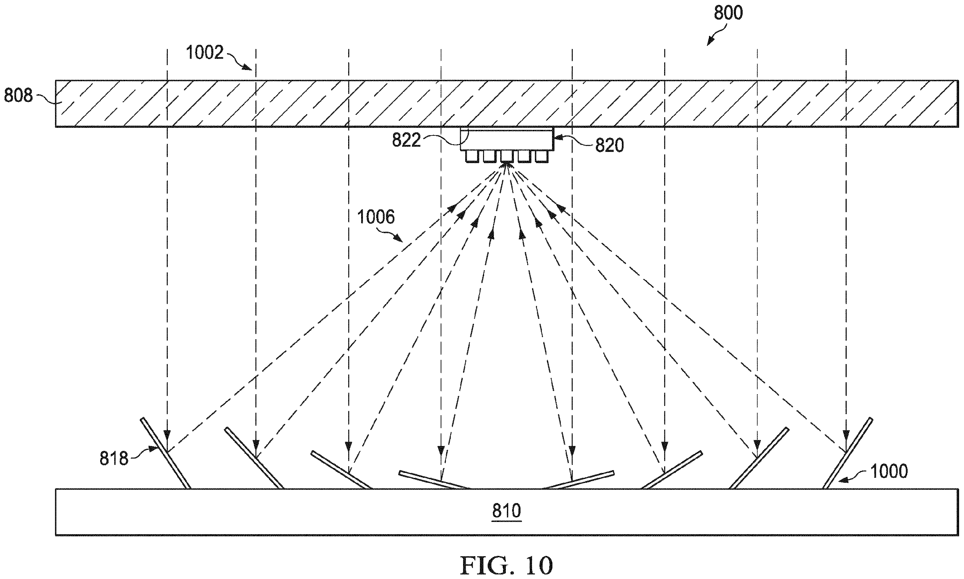

With reference now to **Figure 10****,** an illustration of a cross-sectional view of solar array **800** from **Figure 8** is depicted in accordance with an illustrative example. In this illustrative example, a cross-sectional view of solar array **800** from **Figure 8** is depicted taken in the view of lines **10-10** in **Figure 8****.** However, in this illustrative example, the secondary optical device mounted onto solar cell **820** in **Figure 8** has been optionally excluded.

As depicted, portion **1000** of group of reflectors **818** may be seen. Beam of light **1002** may pass through coverglass **808** and become incident on group of reflectors **818.** Beam of light **1002** is reflected by group of reflectors **818** in the form of reflections **1006** that are focused onto a focal point of solar cell **820.** In this illustrative example, beam of light **1002** may pass through coverglass **808** at an angle perpendicular to coverglass **808.**

However, the angle at which beam of light **1002** passes through coverglass **808** may change over time. A control module, such as control module **618** in **Figure 6****,** may be used to reposition one or more reflectors in group of reflectors **818** to ensure that the electrical output of solar cell **820** is kept at or above a selected threshold.

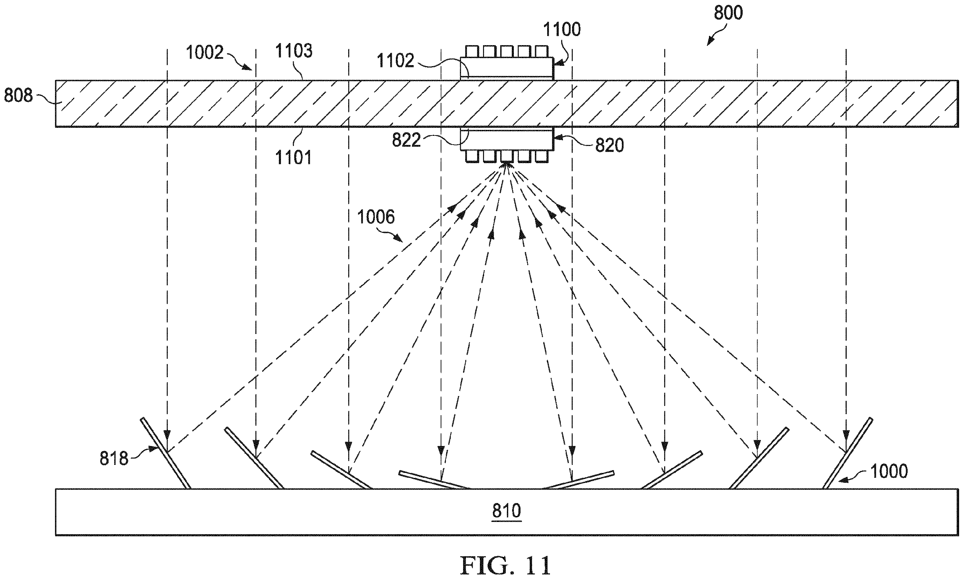

With reference now to **Figure 11****,** an illustration of solar array **800** from **Figure 10** having a threshold solar cell is depicted in accordance with an illustrative example. As depicted, coverglass **808** has first side **1101** and second side **1103.** Solar cell **820** may be mounted to first side **1101,** while threshold solar cell **1100** may be mounted to second side **1103.** Threshold solar cell **1100** may be an example of one implementation for one of set of threshold solar cells **628** in **Figure 6****.** Further, threshold solar cell **1100** may be an example of one implementation for threshold solar cell **632** in **Figure 6****.**

As depicted, in a manner similar to the mounting of solar cell **820** to first side **1101** of coverglass **808** through interconnect **822,** threshold solar cell **1100** is mounted to second side **1103** of coverglass **808** through interconnect **1102.** Threshold solar cell **1100** is mounted upwards-facing such that threshold solar cell **1100** may measure the intensity of the light around solar array **800.**

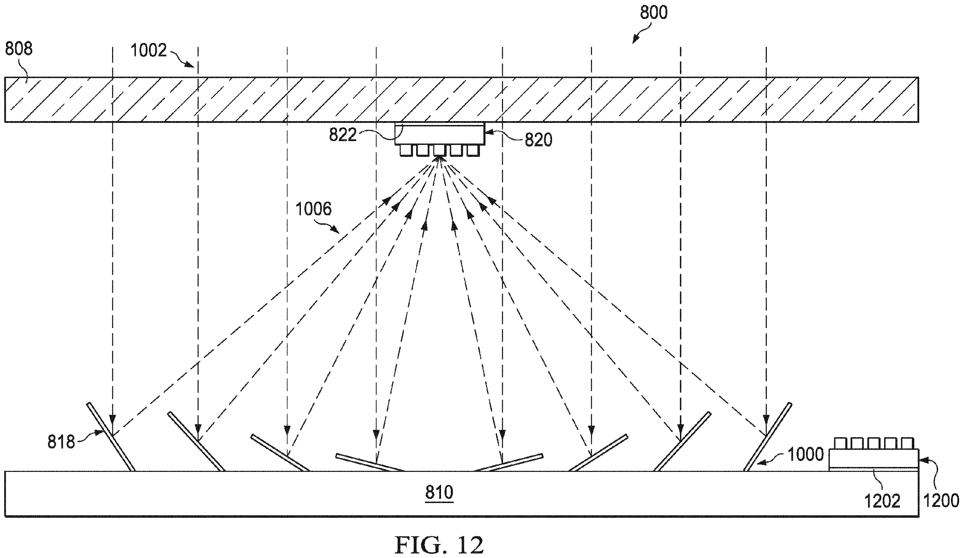

With reference now to **Figure 12****,** another illustration of solar array **800** from **Figure 10** having a threshold solar cell is depicted in accordance with an illustrative example. As depicted, threshold solar cell **1200** may be mounted to and supported by substrate **810.** Threshold solar cell **1200** may be an example of one implementation for one of set of threshold solar cells **628** in **Figure 6****.** Further, threshold solar cell **1200** may be an example of one implementation for threshold solar cell **632** in **Figure 6****.**

As depicted, threshold solar cell **1200** is mounted to substrate **810** through interconnect **1202.** Threshold solar cell **1200** is mounted upwards-facing such that threshold solar cell **1200** may measure the intensity of the light around solar array **800.**

The illustrations of solar array **800** in **Figures 8****,** **10** **11****,** and **12****,** and solar array system **900** in **Figure 9** are not meant to imply physical or architectural limitations to the manner in which an illustrative example may be implemented. Other components in addition to or in place of the ones illustrated may be used. Some components may be optional.

The different components shown in **Figures 1-4****,** **Figure 5****,** and **Figures 8****-12** may be illustrative examples of how components shown in block form in **Figure 6** can be implemented as physical structures. Additionally, some of the components in **Figures 1-4****,** **Figure 5****,** and **Figures 8****-12** may be combined with components in **Figure 6****,** used with components in **Figure 6****,** or a combination of the two.

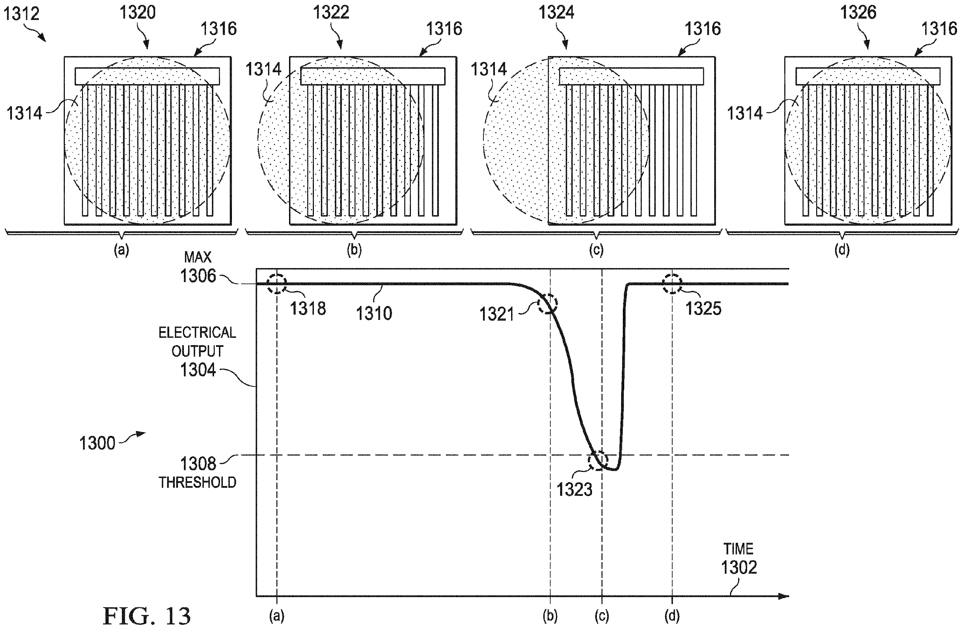

With reference now to **Figure 13****,** an illustration of a graph of an electrical output corresponding to a changing position of a light source is depicted in accordance with an illustrative example. In this illustrative example, graph **1300** includes horizontal axis **1302** and vertical axis **1304.** Horizontal axis **1302** is time, while vertical axis **1304** may be electrical output. The electrical output may be the voltage output, current output, or power output of a solar cell, such as solar cell **820** in **Figures 8****,** **10****,** **11****,** and **12****.**

Selected threshold **1308** may be the threshold level of electrical output computed based on the intensity data generated by a threshold solar cell, such as threshold solar cell **1100** in **Figure 11** or threshold solar cell **1200** in **Figure 12****.** Curve **1310** indicates how electrical output changes over time in response to the changing position of a light source.

For example, curve **1310** indicates how electrical output changes over time based on the different positions **1312** of spot of light **1314** focused on solar cell **1316.** Spot of light **1314** may be a "focused spot" created by the reflectors in the solar array to which solar cell **1316** belongs reflecting light onto solar cell **1316.** In this illustrative example, spot of light **1314** is shown as circular. However, in other illustrative examples, spot of light **1314** may have some other shape. For example, spot of light **1314** may be oval, elliptical, square, rectangular, or have some other type of shape.

Point **1318** along curve **1310** corresponds to position **1320** for spot of light **1314.** At point **1318,** the maximum electrical output is generated by solar cell **1316** due to spot of light **1314** being fully focused on solar cell **1316.** In other words, the reflectors in the solar array are positioned such that light is reflected in a manner that creates spot of light **1314** at position **1320.**

When the light source moves, spot of light **1314** that is created may also move relative to solar cell **1316.** As indicated by point **1321** along curve **1310,** when spot of light **1314** has position **1322** relative to solar cell **1316,** the electrical output may drop below the maximum electrical output. As indicated by point **1323** along curve **1310,** when spot of light **1314** has position **1324** relative to solar cell **1316,** the electrical output may drop below selected threshold **1308.**

When the electrical output drops below selected threshold **1308,** the reflectors in the solar array may be repositioned to "refocus" the reflected light onto solar cell **1316.** In particular, at least one of the reflectors in the solar array may be repositioned with respect to at least one axis. For example, at least one of the reflectors may be tilted at a different angle with respect to at least one axis. This type of refocusing repositions spot of light **1314** such that spot of light **1314** may have position **1326** relative to solar cell **1316.** With spot of light **1314** having position **1326,** the electrical output generated by solar cell **1316** may again reach the maximum electrical output, as indicated by point **1325** along curve **1310.**

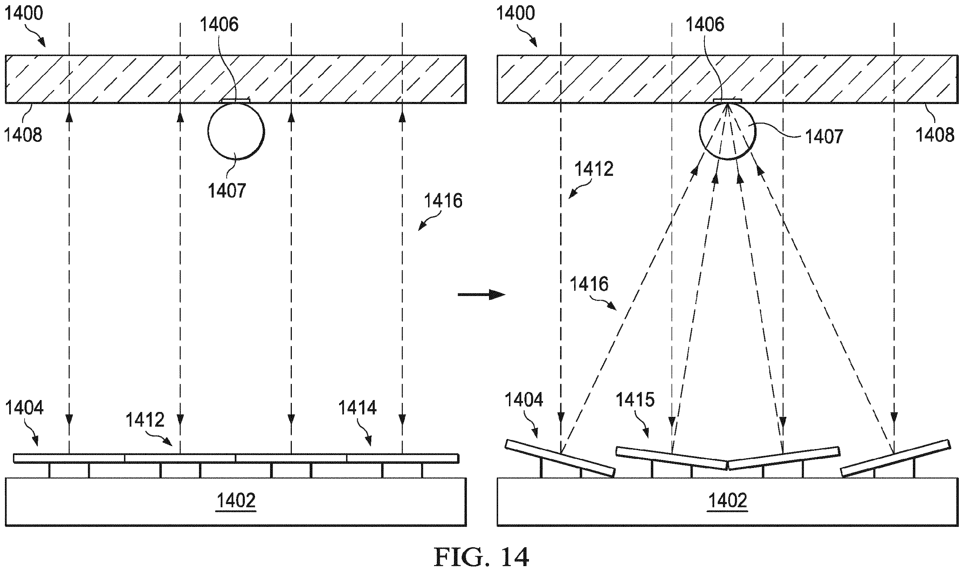

With reference now to **Figure 14****,** an illustration of a side view of a group of reflectors in default positions and in calibrated positions is depicted in accordance with an illustrative example. In this illustrative example, a side view of a portion of solar array **1400** is depicted. Solar array **1400** includes substrate **1402,** group of reflectors **1404,** solar cell **1406,** secondary optics **1407,** and coverglass **1408.**

As depicted, light **1412** is being received by group of reflectors **1404.** The reflectors in group of reflectors **1404** are in default positions **1414.** Default positions **1414** are examples of implementations for default position **705** in **Figure 7****.** In default positions **1414,** these reflectors are positioned substantially parallel to substrate **1402.** With default positions **1414,** reflected light **1416** is not focused onto solar cell **1406.**

However, as depicted, when the reflectors in group of reflectors **1404** are moved into calibrated positions **1415,** reflected light **1416** is focused onto solar cell **1406.** Calibrated positions **1415** are examples of implementations for calibrated position **707** in **Figure 7****.**

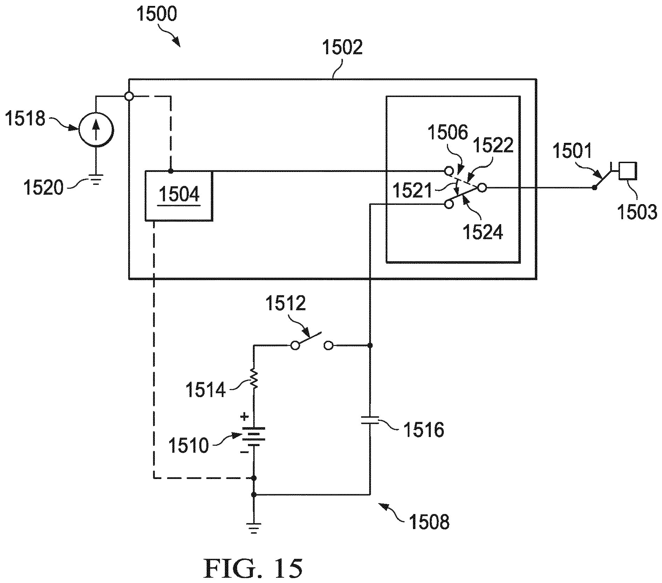

With reference now to **Figure 15****,** a schematic diagram of a calibration system is depicted in accordance with an illustrative example. In this illustrative example, a schematic diagram of calibration system **1500** is depicted in accordance with an illustrative example. Calibration system **1500** may be an example of calibration system **700** described in **Figure 7****.** In this illustrative example, calibration system **1500** is at least partially implemented using control module **1502,** which may be an example of control module **618** in **Figure 1****.**

In this illustrative example, calibration system **1500** is used for calibrating reflector **1503** that is connected to actuation device **1501.** Reflector **1503** may take the form of a micro-electromechanical systems based reflector, which may take the form of a micro-electromechanical systems based mirror. Actuation device **1501** is an example of actuation device **709** in **Figure 7****.**

Calibration system **1500** includes voltage manager **1504,** selector **1506,** and calibration circuit **1508.** Voltage manager **1504,** selector **1506** and calibration circuit **1508** may be examples of implementations for voltage manager **714,** selector **710,** and calibration circuit **712,** respectively, in **Figure 7****.** When tracking a light source, voltage manager **1504** determines the voltage that needs to be applied to actuation device **1501** to best focus reflector **1503** associated with actuation device **1501.**

In this illustrative example, calibration circuit **1508** includes rechargeable battery **1510,** switch device **1512,** resistor **1514,** and capacitor **1516.** Rechargeable battery **1510,** switch device **1512,** resistor **1514,** and capacitor **1516** may be examples of implementations for rechargeable battery **726**, switch device **722,** set of resistors **738,** and set of capacitors **736,** respectively, in **Figure 7****.** In this illustrative example, switch device **1512** is shown open, which may be an example of first state **732** in **Figure 7****.**

Electrical output **1518** from one or more solar cells (not shown), which are connected to ground **1520,** is received at control module **1502.** When selector **1506** is in tracking state **1522,** voltage manager **1504** is electrically connected to actuation device **1501,** while calibration circuit **1508** is electrically disconnected from actuation device **1501.**

Voltage manager **1504** uses at least a portion of electrical output **1518** to supply power to actuation device **1501.** When electrical output **1518** drops to substantially zero in this illustrative example, voltage manager **1504** may control selector **1506** to move selector **1506** in the direction of arrow **1521** from tracking state **1522** to calibrating state **1524,** thereby electrically connecting calibration circuit **1508** to actuation device **1501** and electrically disconnecting voltage manager **1504** from actuation device **1501.**

With selector **1506** in calibrating state **1524,** electrical power is allowed to flow from calibration circuit **1508** to actuation device **1501** when capacitor **1516** is charged. However, capacitor **1516** may not yet be storing any energy. Thus, the voltage being applied to actuation device **1501** is substantially zero such that reflector **1503** is in a default position.

At some point in time after selector **1506** moving to calibrating state **1524,** switch device **1512** may be closed. This closing action may be performed in response to a manual action by a human, a mechanical operation, receiving an electrical signal, or some other action. When switch device **1512** is closed, rechargeable battery **1510** begins charging capacitor **1516** and sending power to actuation device **1501.** With the aid of the voltage divider provided by resistor **1514** and capacitor **1516,** the voltage applied to actuation device **1501** increases until a calibration voltage is reached. The calibration voltage is the voltage needed to operate actuation device **1501** such that reflector **1503** is tilted into the proper calibration position.

Switch device **1512** remains closed only for a preselected period of time before reopening in this illustrative example. This preselected period of time may be a period of time less than the time needed to fully charge capacitor **1516.** The preselected period of time may be in, for example, without limitation, seconds, milliseconds, or some other unit of time. In one illustrative example, the preselected period of time may be between about 2 milliseconds and about 50 milliseconds. Once switch device **1512** opens, the calibration voltage being applied to actuation device **1501** is maintained using resistor **1514** and capacitor **1516** that begins discharging.

With actuation device **1501** receiving the calibration voltage, the calibration position of reflector **1503** is also maintained such that electrical output **1518** may be increased. When electrical output **1518** has increased sufficiently such that dynamic tracking of the light source may be initiated, voltage manager **1504** controls selector **1506** to move selector **1506** from calibrating state **1524** to tracking state **1522.** If capacitor **1516** discharges before tracking of the light source can be initiated, switch device **1512** may be closed again and the process described above repeated.

In some cases, voltage manager **1504** may use a portion of electrical output **1518** to recharge rechargeable battery **1510.** In other words, a portion of electrical output **1518** may be siphoned off to recharge rechargeable battery **1510.**

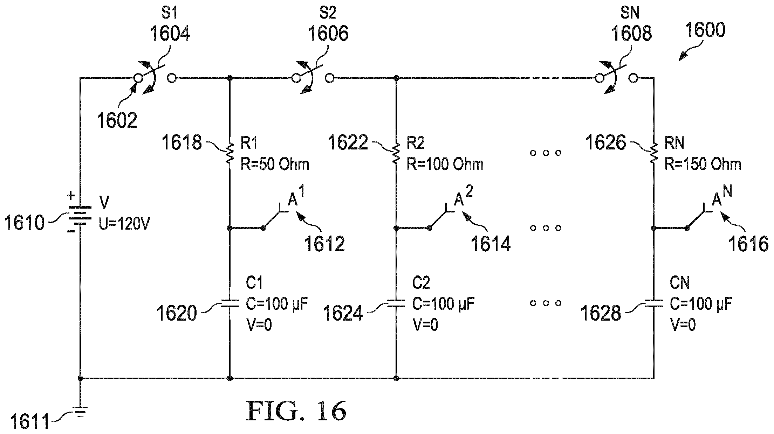

With reference now to **Figure 16****,** a schematic diagram of a calibration circuit is depicted in accordance with an illustrative example. In this illustrative example, calibration circuit **1600** may be an example of one implementation for calibration circuit **712** in **Figure 7****.**

Calibration circuit **1600** includes switch device **1602.** Switch device **1602** includes switch member **1604,** switch member **1606,** and switch member **1608.** In this manner, switch device **1602** may include any number of switch members. In this illustrative example, switch device **1602** is configured such that all of switch members of switch device **1602** open substantially simultaneously and close substantially simultaneously.

Switch member **1604,** switch member **1606,** and switch member **1608** may control when rechargeable battery **1610** is used to power actuation device **1612,** actuation device **1614,** and actuation device **1614,** respectively. Rechargeable battery **1610** is connected to ground **1611.** In one illustrative example, actuation device **1612,** actuation device **1614,** and actuation device **1614** are an example of one implementation for set of actuation devices **708** in **Figure 7****.** In this example, actuation device **1612,** actuation device **1614,** and actuation device **1614** may all correspond to a same reflector. In other illustrative examples, each of actuation device **1612,** actuation device **1614,** and actuation device **1614** may correspond to a different reflector.

As depicted, calibration circuit **1600** also includes resistor **1618,** capacitor **1620,** resistor **1622,** capacitor **1624,** resistor **1626,** and capacitor **1628.** In this illustrative example, the resistance of each of these resistors and the capacitance of each of these capacitors enables the proper calibration voltage to be substantially maintained at each of actuation device **1612,** actuation device **1614,** and actuation device **1616.**

The illustrations of solar array **1400** in **Figure 14****,** calibration system **1500** in **Figure 15****,** and calibration circuit **1600** in **Figure 16** are not meant to imply physical or architectural limitations to the manner in which an illustrative example may be implemented. Other components in addition to or in place of the ones illustrated may be used. Some components may be optional.

The different components shown in **Figures 14-16** may be illustrative examples of how components shown in block form in **Figures 6-7** can be implemented as physical structures or described schematically. Additionally, some of the components in **Figures 14-16** may be combined with components in **Figures 6-7****,** used with components in **Figures 6-7****,** or a combination of the two.

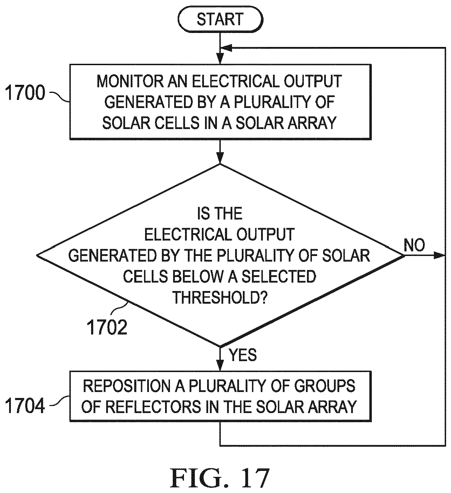

With reference now to **Figure 17****,** an illustration of a process for focusing light onto a plurality of solar cells is depicted in the form of a flowchart in accordance with an illustrative example. The process illustrated in **Figure 17** may be used to, for example, focus a beam of light onto a plurality of solar cells, such as plurality of solar cells **606** in **Figure 6****.**

The process may begin by monitoring an electrical output generated by a plurality of solar cells in a solar array (operation **1700).** Next, a determination may be made as to whether the electrical output generated by the plurality of solar cells is below a selected threshold (operation **1702).** If the electrical output generated by the plurality of solar cells is below the selected threshold, a plurality of groups of reflectors in the solar array are repositioned (operation **1704),** with the process then returning to operation **1700** as described above. Otherwise, if the electrical output generated by the plurality of solar cells is not below the selected threshold, the process returns to operation **1700** as described above.

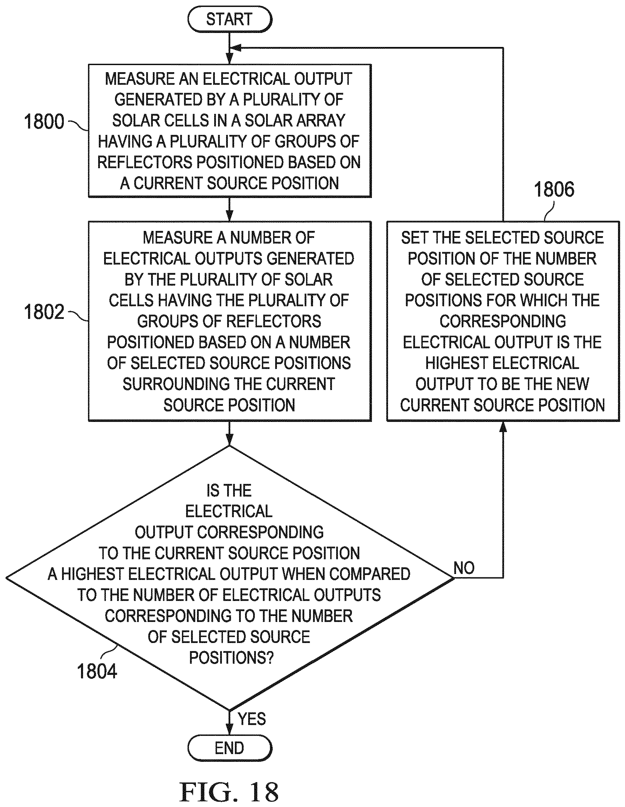

With reference now to **Figure 18****,** an illustration of a process for focusing light onto a solar cell is depicted in the form of a flowchart in accordance with an illustrative example. The process illustrated in **Figure 18** may be used to, for example, focus a beam of light onto a plurality of solar cells, such as plurality of solar cells **606** in **Figure 6****.**

The process may begin by measuring an electrical output generated by a plurality of solar cells in a solar array having a plurality of groups of reflectors positioned based on a current source position (operation **1800).** In operation **1800,** the current source position may be defined as (θ_{focus}, θ_{focus}) . In this manner, the current source position may be an angular position with respect to an axis that is substantially perpendicular to the solar array. Each reflector in each group of reflectors in the plurality of groups of reflectors may be positioned to reflect a beam of light being directed from this current source position to the solar cell of the plurality of solar cells corresponding to that reflector.

Next, a number of electrical outputs generated by the plurality of solar cells having the plurality of groups of reflectors positioned based on a number of selected source positions surrounding the current source position are measured (operation **1802**). In operation **1802,** the plurality of groups of reflectors may be repositioned based on a particular one of the number of selected source positions. The electrical output generated by the plurality of solar cells with the plurality of groups of reflectors being positioned based on this particular selected source position is measured. This process may be repeated for each of the number of selected source positions.

The number of selected source positions may include, for example, 8 positions. These 8 positions may include the following positions: (θ_{focus}+Δθ, φ_{focus}+Δφ), (θ_{focus}+Δθ, φ_{focus}-Δφ), (θ_{focus}-Δθ, φ_{focus}+Δφ), (θ_{focus}-Δθ, φ_{focus}-Δθ), (θ_{focus}, φ_{focus}+Δθ), (φ_{focus}, φ_{focus}-Δφ), (θ_{focus}+Δθ, φ_{focus}), and (θ_{focus}-Δθ, φ_{focus}). In other examples, some other number of selected source positions may be selected. For example, 4, 7, 9, 15, 20, or some other number of positions may be selected.

Thereafter, a determination is made as to whether the electrical output corresponding to the current source position is a highest electrical output when compared to the number of electrical outputs corresponding to the number of selected source positions (operation **1804**). In particular, in operation **1804**, the determination is made as to whether the electrical output corresponding to the current source position or the electrical output corresponding to one of the number of selected source positions is a highest electrical output.

If the electrical output corresponding to the current source position is the highest electrical output, the process terminates. Otherwise, the selected source position of the number of selected source positions for which the corresponding electrical output is the highest electrical output is set to be the new current source position (operation **1806**), with the process then returning to operation **1800** as described above.

The process described in **Figure 18** may be performed repeatedly, continuously, or periodically. For example, the process described in **Figure 18** may be set to repeat at the lapse of a timer or in response to the occurrence of some event.

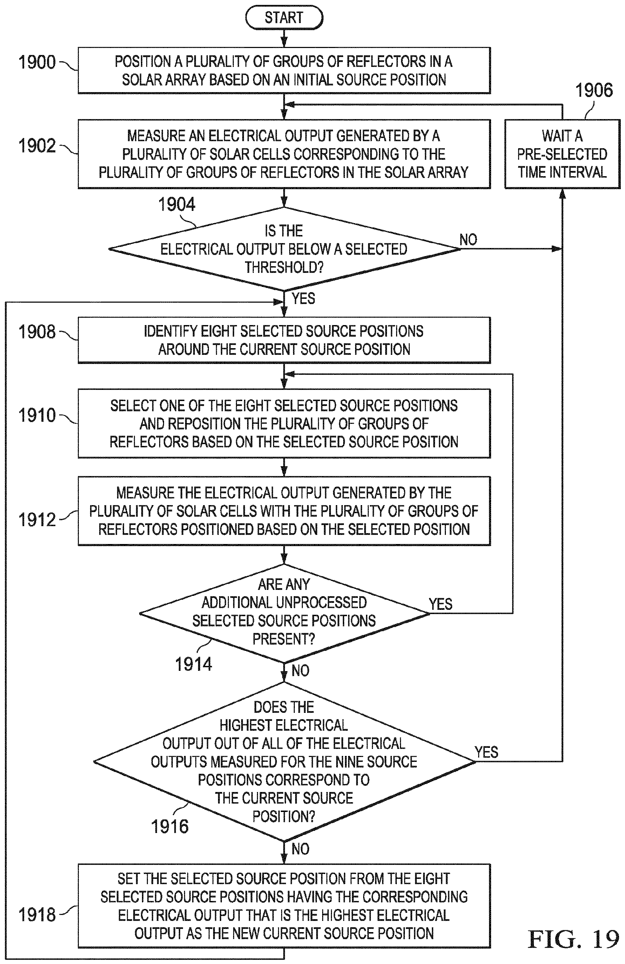

With reference now to **Figure 19**, an illustration of a process for tracking sunlight using a solar array is depicted in the form of a flowchart in accordance with an illustrative example. The process illustrated in **Figure 19** may be implemented to track sunlight using, for example, solar array **604** in **Figure 6**. A similar process may be used to track sunlight using a set of solar arrays, such as set of solar arrays **602** in **Figure 6**.

The process may begin by positioning a plurality of groups of reflectors in a solar array based on an initial source position (operation **1900**). The initial source position, (θ, φ) may be, for example, (0, 0). The initial source position may be the angular position relative to an axis substantially perpendicular to the solar array at which the sun is thought to be positioned. Positioning the plurality of groups of reflectors in operation **1900** may include applying a voltage to the actuation device corresponding to each reflector in the plurality of groups of reflectors such that each reflector is tilted in a manner that enables the highest concentration of light to be focused onto a corresponding solar cell in a plurality of solar cells in the solar array given the assumption that the source of the light is actually at the initial source position.

Next, an electrical output generated by a plurality of solar cells corresponding to the plurality of groups of reflectors in the solar array is measured (operation **1902**). A determination is made as to whether the electrical output is below a selected threshold (operation **1904**). If the electrical output is not below the selected threshold, the process waits a pre-selected time interval (operation **1906**), with the process then returning to operation **1902** as described above.

With reference again to operation **1904**, if the electrical output is below the selected threshold, eight selected source positions around the current source position are identified (operation **1908**). In one illustrative example, the eight selected source positions may be 1 degree offsets from the current source position (θ, φ). For example, the eight selected source positions may be (θ-1°, φ-1°), (θ+1°, φ-1°), (θ+1°, φ+1°), (θ+1°, φ+1°), (θ, φ-1°), (θ, φ+1°), (θ-1°, φ), and (θ+1°, φ).

Thereafter, one of the eight selected source positions is selected and the plurality of groups of reflectors is repositioned based on the selected source position (operation **1910**). Next, the electrical output generated by the plurality of solar cells is measured with the plurality of groups of reflectors positioned based on the selected source position (operation **1912**). The process then determines whether any additional unprocessed selected source positions are present (operation **1914**). If any additional unprocessed selected source positions are present, the process returns to operation **1910**. Otherwise, the process determines whether the highest electrical output out of all the electrical outputs measured for the nine source positions corresponds to the current source position (operation **1916**). The nine source positions include the eight selected source positions and the current source position.

If the highest electrical output out of all of the electrical outputs measured for the nine source positions corresponds to the current source position, the process proceeds to operation **1906** as described above. Otherwise, the selected source position from the eight selected source positions having the corresponding electrical output that is the highest electrical output is set as the new current source position (operation **1918**), with the process then returning to operation **1908** as described above.

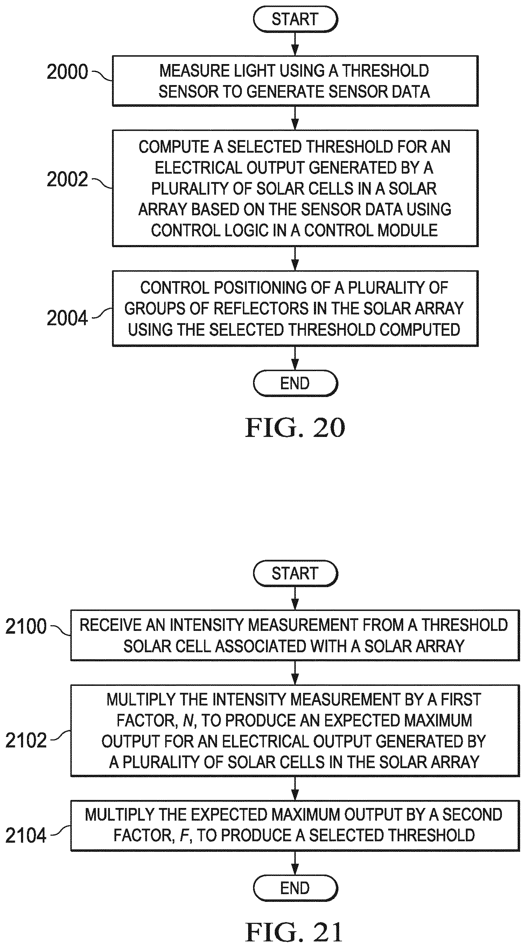

With reference now to **Figure 20**, an illustration of a process for managing a solar array is depicted in the form of a flowchart in accordance with an illustrative example. The process illustrated in **Figure 20** may be implemented to manage solar array **604** in **Figure 6**.

The process may begin by measuring light using a threshold sensor to generate sensor data (operation **2000**). In one illustrative example, the threshold sensor may take the form of a threshold solar cell. In some illustrative examples, the sensor data may be generated by more than one threshold sensor. The sensor data may include measurements of intensity, current, voltage, power, some other parameter that can be correlated with the intensity of the light, or some combination thereof.

Then, a selected threshold is computed for an electrical output generated by a plurality of solar cells in a solar array based on the sensor data using control logic in a control module (operation **2002**). Thereafter, positioning of a plurality of groups of reflectors in the solar array is controlled using the selected threshold computed (operation **2004**), with the process terminating thereafter.

With reference now to **Figure 21**, an illustration of a process for computing a selected threshold for an electrical output of a solar array is depicted in the form of a flowchart in accordance with an illustrative example. The process illustrated in **Figure 21** may be implemented to manage solar array **604** in **Figure 6**. This process may be used to dynamically set, for example, without limitation, selected threshold **624** for electrical output **622** generated by solar array **604** in **Figure 6**.

The process may begin by receiving an intensity measurement from a threshold solar cell associated with a solar array (operation **2100**). The intensity measurement in operation **2100** may be a measurement of the intensity of light around the solar array.

The threshold solar cell may be mounted to a coverglass of a solar array, a substrate of a solar array, or some other component of a solar array. The threshold solar cell may be positioned with respect to the various components of the solar array to ensure that a desired amount of light reaches the threshold solar cell based on the position of the light source.

Next, the intensity measurement is multiplied by a first factor, n, to produce an expected maximum output for an electrical output generated by a plurality of solar cells in the solar array (operation **2102**). The expected maximum output is then multiplied by a second factor, f, to produce a selected threshold (operation **2104**), with the process terminating thereafter.

The selected threshold computed in operation **2104** may be set such that any drop in the electrical output generated by the plurality of solar cells in the solar array below the selected threshold triggers a refocusing of the solar array. In other words, at least one reflector in the solar array may be repositioned with respect to at least one axis to refocus the light onto the plurality of solar cells.

This process may be repeated any number of times during the operation of the solar array to ensure that the selected threshold being used to trigger refocusing of the reflectors in the solar array takes into account the light. This type of dynamic setting of the selected threshold may improve overall performance of the solar array.

Although the selected threshold is described as being computed using two factors in **Figure 21**, any number of scale factors, algorithms, mathematical formulas, equations, or combination thereof may be used to compute the selected threshold in other illustrative examples. Further, the factors used to compute the selected threshold may be selected based on the level of performance desired for the solar array.

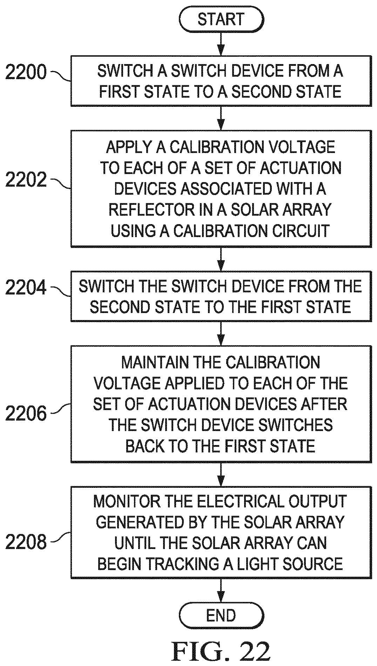

With reference now to **Figure 22**, an illustration of a process for calibrating a reflector is depicted in the form of a flowchart in accordance with an illustrative example. The process illustrated in **Figure 22** may be implemented to calibrate a reflector, such as reflector **704** in **Figure 7**, using a calibration system, such as calibration system **700** in **Figure 7**.

The process begins by switching a switch device from a first state to a second state (operation **2200**). A calibration voltage is applied to each of a set of actuation devices associated with a reflector in a solar array using a calibration circuit in response to the switch device switching to the second state when the calibration circuit is electrically connected to the set of actuation devices (operation **2202**). In operation **2202**, applying the calibration voltage to each of the set of actuation devices positions the reflector in a calibrated position, which may be angled relative to the substrate with which the reflector is coupled.

The switch device switches from the second state to the first state in response to an event occurring (operation **2204**). In operation **2204**, the event may be, for example, event **735** described in **Figure 7**. The event may include the occurrence of at least one of the lapse of a preselected period of time or timer, receiving an electrical signal, or the voltage being applied to each of the set of actuation devices reaching the calibration voltage.

The calibration voltage applied to each of the set of actuation devices is maintained after the switch device switches back to the first state (operation **2206**). The electrical output generated by the solar array is monitored until the solar array can begin tracking a light source (operation **2208**), with the process terminating thereafter.

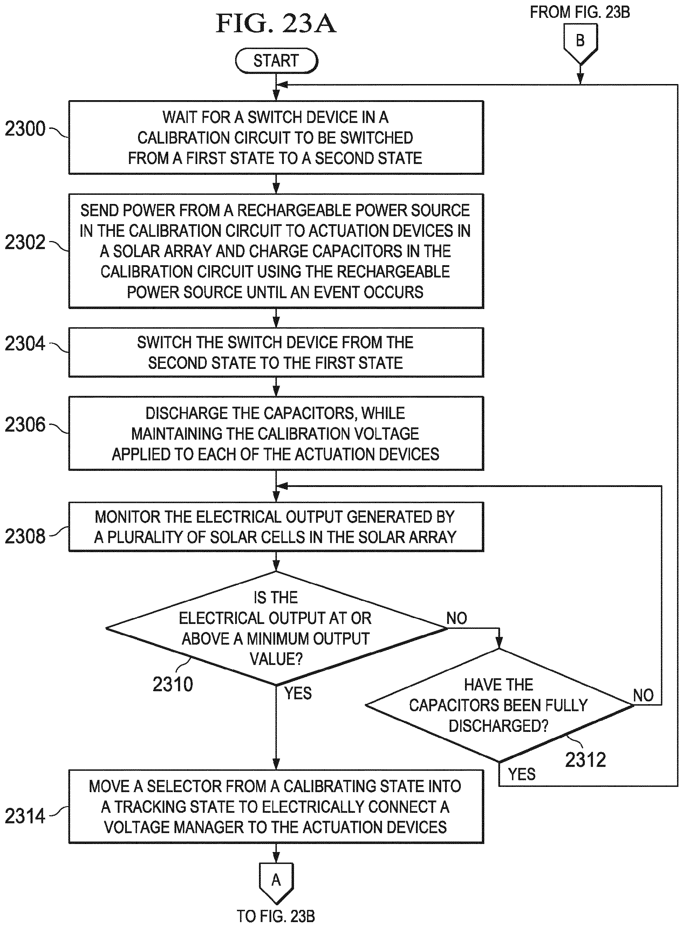

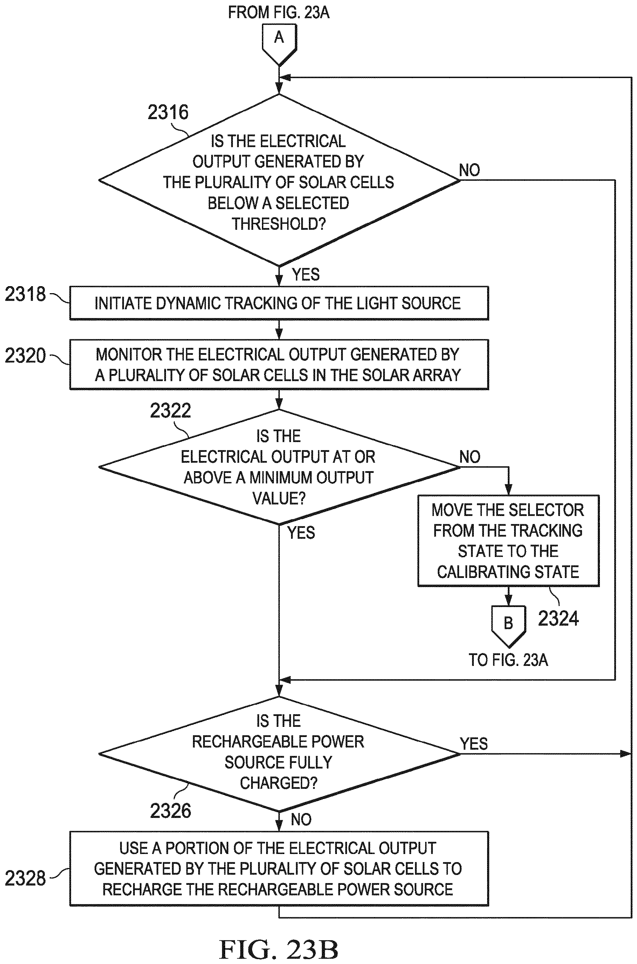

With reference now to **Figures 23A** and **23B**, illustrations of a process for calibrating and managing a solar array are depicted in the form of a flowchart in accordance with an illustrative example. The process described in **Figures 23A** and **23B** may be used to calibrate and manage a solar array, such as solar array **604** in **Figure 6**. The process described in **Figures 23A** and **23B** begins with the voltage being applied to each of the actuation devices in the solar array being substantially zero.

In particular, the process begins by waiting for a switch device in a calibration circuit to be switched from a first state to a second state (operation **2300**). Once the switch device has been switched from the first state to the second state, power is sent from a rechargeable power source in the calibration circuit to actuation devices in a solar array and capacitors in the calibration circuit are charged using the rechargeable power source until an event occurs (operation **2302**).

In operation **2302**, the event may be the lapse of a preselected period of time or timer. The preselected period of time may be the time needed to increase the voltages being applied to the actuation devices to calibration voltages and to charge the capacitors such that the calibration voltages can be maintained. In operation **2302**, the calibration voltage may be the same or different event for the different actuation devices. Applying the corresponding calibration voltage to each of the actuation devices moves the corresponding reflectors in the solar array into calibrated positions.

In response to the event occurring, the switch device is switched from the second state to the first state (operation **2304**). The capacitors discharge, while maintaining the calibration voltage applied to each of the actuation devices (operation **2306**). In operation **2306**, resistors in the calibration circuit help maintain the calibration voltage that is applied to each of the actuation devices.

The electrical output generated by a plurality of solar cells in the solar array is monitored (operation **2308**). A determination is made as to whether the electrical output is at or above a minimum output value (operation **2310**). If the electrical output is not at or above the minimum output value, a determination is made as to whether the capacitors have been fully discharged (operation **2312**).

If the capacitors have not been fully discharged, the process returns to operation **2308** described above. Otherwise, the process returns to operation **2300** described above. With reference again to operation **2310**, if the electrical output is at or above a minimum output value, a selector is moved from a calibrating state into a tracking state to electrically connect a voltage manager to the actuation devices (operation **2314**).

A determination is made as to whether the electrical output generated by the plurality of solar cells is below a selected threshold (operation **2316**). If the electrical output is below the selected threshold, the process initiates dynamic tracking of the light source (operation **2318**). Operation **2318** may be performed in a manner similar to the process that includes performing, for example, without limitation, operations **1906**, **1908**, **1910**, **1912**, **1914**, **1916**, and **1918** in **Figure 19**.

The electrical output generated by a plurality of solar cells in the solar array is monitored (operation **2320**). A determination is made as to whether the electrical output is at or above a minimum output value (operation **2322**). If the electrical output is not at or above a minimum output value, the selector is moved from the tracking state to the calibrating state (operation **2324**), with the process then returning to operation **2300** described above.

Otherwise, if the electrical output is at or above a minimum output value, a determination is made as to whether the rechargeable power source is fully charged (operation **2326**). If the rechargeable power source is fully charged, the process returns to operation **2316** described above. Otherwise, a portion of the electrical output generated by the plurality of solar cells is used to recharge the rechargeable power source (operation **2328**), with the process then returning to operation **2316** described above. With reference again to operation **2316**, if the electrical output generated by the plurality of solar cells is not below the selected threshold, the process proceeds to operation **2326** described above.

The flowcharts and block diagrams in the different depicted examples illustrate the architecture, functionality, and operation of some possible implementations of apparatuses and methods in an illustrative example. In this regard, each block in the flowcharts or block diagrams may represent a module, a segment, a function, a portion of an operation or step, some combination thereof.

In some alternative implementations of an illustrative example, the function or functions noted in the blocks may occur out of the order noted in the figures. For example, in some cases, two blocks shown in succession may be executed substantially concurrently, or the blocks may sometimes be performed in the reverse order, depending upon the functionality involved. Also, other blocks may be added in addition to the illustrated blocks in a flowchart or block diagram.

Thus, the illustrative examples provide a method and apparatus for managing a solar array. Light may be measured using one or more threshold sensors to generate sensor data. A selected threshold may be computed for an electrical output generated by a plurality of solar cells in the solar array based on the sensor data using control logic in a control module. Positioning of a plurality of groups of reflectors in the solar array is controlled using the selected threshold computed.

By computing the selected threshold based on the sensor data, changes in the position of the light source, in the environment around the solar array, or both may be taken into account to ensure that the selected threshold is properly set. If the selected threshold is set too low, then the focused light on the plurality of solar cells in the solar array may eventually wander off the plurality of solar cells to the point that the solar array may be unable to generate the desired amount of power. Conversely, if the selected threshold is set too high, then the solar array may be unable to reach a focused state and may just turn off.

Thus, using a set of threshold sensors to ensure that the amount of light expected to be detected corresponds with the amount of light that is actually available for detection may improve the overall performance of the solar array. Dynamically setting the selected threshold with the capability to adjust the selected threshold over time based on changing conditions may improve the ability of the solar array to dynamically track a light source over time in these changing conditions.

The description of the different illustrative examples has been presented for purposes of illustration and description, and is not intended to be exhaustive or limited to the examples in the form disclosed. Many modifications and variations will be apparent to those of ordinary skill in the art. Further, different illustrative examples may provide different features as compared to other desirable examples. The example or examples selected are chosen and described in order to best explain the principles of the examples, the practical application, and to enable others of ordinary skill in the art to understand the disclosure for various examples with various modifications as are suited to the particular use contemplated.

## Claims

1. An apparatus comprising:
a set of actuation devices (708) associated with a reflector (704) in a solar array (604); and
a selector (710) operable to switch between a tracking state (713) and a calibrating state (715), and
a voltage manager (714) and a calibration circuit (712) configured to be electrically connected/disconnected to/from the set of actuation devices (708) depending on a state of the selector (710), said voltage manager (714) is configured to control the selector (710) based on an electrical output (622) of the solar array (604), such that
when the selector (710) is switched by the voltage manager (714) in the tracking state (713), said voltage manager (714) is configured to be connected to the set of actuation devices (708) and the calibration circuit (712) is configured to be disconnected form the set of actuation devices (708), wherein said voltage manager (714) is configured to supply at least a portion of the electrical output (622) to the set of actuation devices (708); and
when the selector (710) is switched by the voltage manager (714) in the calibrating state (715), the calibration circuit (712) is configured to be electrically connected to the set of actuation devices (708) and the voltage manager (714) is configured to be disconnected from the set of actuation devices (708), wherein
the calibration circuit (712) comprises:
a power source (716);
a set of capacitors (718);
a set of resistors (720); and
a switch device (722) operable to switch between a first state (732) and a second state (734),
wherein switching the switch device (722) from the first state (732) to the second state (734) causes the calibration circuit (712) to apply a calibration voltage from the power source (716) to each of the set of actuation devices (708) when the calibration circuit (712) is electrically connected to the set of actuation devices (708), and
wherein switching the switch device (722) from the second state (734) to the first state (732) causes the calibration circuit (712) to stop supplying the power from the power source (716).

2. The apparatus of claim 1, wherein the calibration circuit (712) maintains the calibration voltage applied to each actuation device of the set of actuation devices (708) after the switch device (722) switches from the second state (734) to the first state (732).

3. The apparatus of claim 1 or 2,
wherein each of the set of capacitors (736) charges while the switch device (722) is in the second state (734) and discharges after the switch device (722) switches from the second state (734) to the first state (732).

4. The apparatus of claim 3, wherein:
the power source (716) is configured to charge the set of capacitors (736); and said calibration circuit (712) further comprises:
a set of resistors (738) that control a charging rate and a discharging rate of the set of capacitors (736), optionally
wherein the power source (716) is a rechargeable power source (721).

5. The apparatus of claim 4, wherein the rechargeable power source (721) is selected from one of a rechargeable battery (726), a capacitor bank (728), and an inductor bank (727) .

6. The apparatus of any of claims 1-5,
wherein the selector (710) is moved from the tracking state (713) to the calibrating state (715) when said electrical output (622) of the solar array (604) drops below a minimum output value (717).

7. The apparatus of claim 1, wherein the reflector (704) is a micro-electromechanical systems based reflector.

8. The apparatus of claim 1, wherein applying the calibration voltage to each of the set of actuation devices (708) positions the reflector (704) in a calibrated position (707).

9. The apparatus of claim 8 further comprising:
a substrate (609), wherein the reflector (704) is coupled to the substrate (609)and wherein the calibrated position (707) for the reflector (704) is rotationally offset with respect to at least one axis relative to a plane of the substrate (609).

10. A solar array (604) comprising:
a plurality of reflectors (702);
a plurality of actuation devices (706) associated with the plurality of reflectors (702);
a plurality of solar cells (606) that generate an electrical output (622);
a selector (710) operable to switch between a tracking state (713) and a calibrating state (715);
a voltage manager (714) and a calibration circuit (712) configured to be electrically connected/disconnected to/from the plurality of actuation devices (706) depending on a state of the selector (710), said voltage manager (714) is configured to control the selector (710) based on said electrical output (622), such that
when the selector (710) is switched by the voltage manager (714) in the tracking state (713) said voltage manager (714) is configured to be connected to the plurality of actuation devices (706) and the calibration circuit (712) is configured to be disconnected form the plurality of actuation devices (706), wherein said voltage manager (714) is configured to supply at least a portion of the electrical output (622) to the plurality of actuation devices (706);, and
when the selector (710) is switched by the voltage manager (714) in the calibrating state (715), the calibration circuit (712) is configured to be electrically connected to the plurality of actuation devices (706) and the voltage manager (714) is configured to be disconnected from the plurality of actuation devices (706), wherein
the calibration circuit (712) comprises:
a power source (716);
a plurality of capacitors (718);
a plurality of resistors (720); and
a switch device (722) operable to switch between a first state (732) and a second state (734),
wherein switching the switch device (722) from the first state (732) to the second state (734) causes the calibration circuit (712) to apply a calibration voltage from the power source (716) to each of the plurality of actuation devices (706) when the calibration circuit (712) is electrically connected to the plurality of actuation devices (706); and
wherein switching the switch device (722) from the second state (734) to the first state (732) causes the calibration circuit (712) to stop supplying the power from the power source (716).

11. The solar array (604) of claim 10, wherein the calibration circuit (712) maintains the calibration voltage applied to each actuation device of the plurality of actuation devices (706) after the switch device (722) switches from the second state (734) to the first state (732),
wherein each of the plurality of capacitors (718) charges while the switch device (722) is in the second state (734) and discharges after the switch device (722) switches from the second state (734) to the first state (732).

12. A method for calibrating a reflector (704) in a solar array (604) of any of claims 10-11, the method comprising:
moving a selector (710) from a tracking state (713) to a calibrating state (715) to electrically connect the calibration circuit (712) to the set of actuation devices (708);
switching (2200) a switch device (722) from a first state (732) to a second state (734); and
applying (2202) a calibration voltage to each of a set of actuation devices (708) associated with the reflector (704) in response to the switch device (722) switching to the second state (734) when a calibration circuit (712) is electrically connected to the set of actuation devices (708).

13. The method of claim 12 further comprising:
maintaining (2206) the calibration voltage applied to each actuation device of the set of actuation devices (708) after the switch device (722) switches from the second state (734) to the first state (732).

14. The method of claim 13 further comprising:
switching (2204) the switch device (722) from the second state (734) to the first state (732) in response to an event (735) occurring, wherein the event (735) is selected from one of a lapse of a preselected period of time and receiving an electrical signal.

15. The method of claim 12, wherein applying (2202) the calibration voltage comprises:
applying the calibration voltage to each actuation device of the set of actuation devices (708) using a power source and a set of capacitors (736) in the calibration circuit (712), optionally further comprising:
maintaining the calibration voltage at the each actuation device of the set of actuation devices (708) using the set of capacitors (736) and a set of resistors (738) in the calibration circuit (712) after the switch device (722) switches from the second state (734) to the first state (732).

## Patentansprüche

1. Vorrichtung aufweisend:
einen Satz von Aktuatoren (708), die einem Reflektor (704) zugeordnet sind, in einer Solaranlage (604); und
einen Selektor (710), der sich zwischen einem Nachführungszustand (713) und einem Kalibrierungszustand (715) umschalten lässt, und
einen Spannungsmanager (714) und einen Kalibrierungsschaltkreis (712), die konfiguriert sind, abhängig von einem Zustand des Selektors (710) mit/von dem Satz von Aktuatoren (708) elektrisch verbunden/getrennt zu werden, wobei der Spannungsmanager (714) konfiguriert ist, auf Basis einer elektrischen Leistungsabgabe (622) der Solaranlage (604) den Selektor (710) zu steuern, derart, dass
wenn der Selektor (710) von dem Spannungsmanager (714) in den Nachführungszustand (713) umgeschaltet wird, der Spannungsmanager (714) konfiguriert ist, mit dem Satz von Aktuatoren (708) verbunden zu werden, und der Kalibrierungsschaltkreis (712) konfiguriert ist, von dem Satz von Aktuatoren (708) getrennt zu werden, wobei der Spannungsmanager (714) konfiguriert ist, dem Satz von Aktuatoren (708) mindestens einen Teil der elektrischen Leistungsabgabe (622) zuzuführen; und
wenn der Selektor (710) von dem Spannungsmanager (714) in den Kalibrierungszustand (715) umgeschaltet wird, der Kalibrierungsschaltkreis (712) konfiguriert ist, mit dem Satz von Aktuatoren (708) elektrisch verbunden zu werden, und der Spannungsmanager (714) konfiguriert ist, von dem Satz von Aktuatoren (708) getrennt zu werden, wobei
der Kalibrierungsschaltkreis (712) aufweist:
eine Energiequelle (716);
einen Satz von Kondensatoren (718);
einen Satz von Widerständen (720); und
eine Umschaltvorrichtung (722), die sich zwischen einem ersten Zustand (732) und einem zweiten Zustand (734) umschalten lässt,
wobei ein Umschalten der Umschaltvorrichtung (722) aus dem ersten Zustand (732) in den zweiten Zustand (734) bewirkt, dass der Kalibrierungsschaltkreis (712) eine Kalibrierungsspannung aus der Energiequelle (716) an jeden Aktuator des Satzes von Aktuatoren (708) anlegt, wenn der Kalibrierungsschaltkreis (712) mit dem Satz von Aktuatoren (708) elektrisch verbunden ist, und
wobei ein Umschalten der Umschaltvorrichtung (722) aus dem zweiten Zustand (734) in den ersten Zustand (732) bewirkt, dass der Kalibrierungsschaltkreis (712) ein Zuführen von Energie aus der Energiequelle (716) beendet.

2. Vorrichtung nach Anspruch 1, wobei nach Umschalten der Umschaltvorrichtung (722) aus dem zweiten Zustand (734) in den ersten Zustand (732) der Kalibrierungsschaltkreis (712) die an jedem Aktuator des Satzes von Aktuatoren (708) anliegende Kalibrierungsspannung hält.

3. Vorrichtung nach Anspruch 1 oder 2, wobei jeder Kondensator des Satzes von Kondensatoren (736) sich auflädt, während die Umschaltvorrichtung (722) in dem zweiten Zustand (734) ist, und nach Umschalten der Umschaltvorrichtung (722) aus dem zweiten Zustand (734) in den ersten Zustand (732) sich entlädt.

4. Vorrichtung nach Anspruch 3, wobei:
die Energiequelle (716) konfiguriert ist, den Satz von Kondensatoren (736) aufzuladen; und der Kalibrierungsschaltkreis (712) ferner aufweist:
einen Satz von Widerständen (738), die eine Aufladungsrate und eine Entladungsrate des Satzes von Kondensatoren (736) steuern, optional, wobei die Energiequelle (716) eine wiederaufladbare Energiequelle (721) ist.

5. Vorrichtung nach Anspruch 4, wobei die wiederaufladbare Energiequelle (721) ausgewählt ist aus einer wiederaufladbaren Batterie (726), einer Kondensator-Reihe (728) und einer Induktor-Bank (727).

6. Vorrichtung nach einem der Ansprüche 1 bis 5,
wobei der Selektor (710) aus dem Nachführungszustand (713) in den Kalibrierungszustand (715) bewegt wird, wenn die elektrische Leistungsabgabe (622) der Solaranlage (604) einen Leistungsabgabe-Minimumwert (717) unterschreitet.

7. Vorrichtung nach Anspruch 1, wobei der Reflektor (704) ein auf mikroelektromechanischen Systemen basierender Reflektor ist.

8. Vorrichtung nach Anspruch 1, wobei Anlegen der Kalibrierungsspannung an jeden Aktuator des Satzes von Aktuatoren (708) den Reflektor (704) in eine kalibrierte Position (707) positioniert.

9. Vorrichtung nach Anspruch 8, ferner aufweisend:
ein Substrat (609), wobei der Reflektor (704) mit dem Substrat (609) gekoppelt ist, und wobei die kalibrierte Position (707) für den Reflektor (704) rotationsversetzt bezüglich mindestens einer Achse relativ zu einer Ebene des Substrats (609) ist.

10. Solaranlage (604) aufweisend:
eine Vielzahl von Reflektoren (702);
eine Vielzahl von Aktuatoren (706), die der Vielzahl von Reflektoren (702) zugeordnet sind;
eine Vielzahl von Solarzellen (606), die eine elektrische Leistungsabgabe (622) erzeugen;
einen Selektor (710), der sich zwischen einem Nachführungszustand (713) und einem Kalibrierungszustand (715) umschalten lässt;
einen Spannungsmanager (714) und einen Kalibrierungsschaltkreis (712), die konfiguriert sind, abhängig von einem Zustand des Selektors (710) mit/von der Vielzahl von Aktuatoren (706) elektrisch verbunden/getrennt zu werden, wobei der Spannungsmanager (714) konfiguriert ist, auf Basis der elektrischen Leistungsabgabe (622) den Selektor (710) zu steuern, derart, dass
wenn der Selektor (710) von dem Spannungsmanager (714) in den Nachführungszustand (713) umgeschaltet wird, der Spannungsmanager (714) konfiguriert ist, mit der Vielzahl von Aktuatoren (706) verbunden zu werden, und der Kalibrierungsschaltkreis (712) konfiguriert ist, von der Vielzahl von Aktuatoren (706) getrennt zu werden, wobei der Spannungsmanager (714) konfiguriert ist, der Vielzahl von Aktuatoren (706) mindestens einen Teil der elektrischen Leistungsabgabe (622) zuzuführen; und
wenn der Selektor (710) von dem Spannungsmanager (714) in den Kalibrierungszustand (715) umgeschaltet wird, der Kalibrierungsschaltkreis (712) konfiguriert ist, mit der Vielzahl von Aktuatoren (706) elektrisch verbunden zu werden, und der Spannungsmanager (714) konfiguriert ist, von der Vielzahl von Aktuatoren (706) getrennt zu werden, wobei
der Kalibrierungsschaltkreis (712) aufweist:
eine Energiequelle (716);
eine Vielzahl von Kondensatoren (718);
eine Vielzahl von Widerständen (720); und
eine Umschaltvorrichtung (722), die sich zwischen einem ersten Zustand (732) und einem zweiten Zustand (734) umschalten lässt,
wobei ein Umschalten der Umschaltvorrichtung (722) aus dem ersten Zustand (732) in den zweiten Zustand (734) bewirkt, dass der Kalibrierungsschaltkreis (712) eine Kalibrierungsspannung aus der Energiequelle (716) an jeden Aktuator der Vielzahl von Aktuatoren (706) anlegt, wenn der Kalibrierungsschaltkreis (712) mit der Vielzahl von Aktuatoren (706) elektrisch verbunden ist; und
wobei ein Umschalten der Umschaltvorrichtung (722) aus dem zweiten Zustand (734) in den ersten Zustand (732) bewirkt, dass der Kalibrierungsschaltkreis (712) ein Zuführen von Energie aus der Energiequelle (716) beendet.

11. Solaranlage (604) nach Anspruch 10, wobei nach Umschalten der Umschaltvorrichtung (722) aus dem zweiten Zustand (734) in den ersten Zustand (732) der Kalibrierungsschaltkreis (712) die an jedem Aktuator der Vielzahl von Aktuatoren (706) anliegende Kalibrierungsspannung hält,
wobei jeder Kondensator der Vielzahl von Kondensatoren (718) sich auflädt, während die Umschaltvorrichtung (722) in dem zweiten Zustand (734) ist, und nach Umschalten der Umschaltvorrichtung (722) aus dem zweiten Zustand (734) in den ersten Zustand (732) sich entlädt.

12. Verfahren zum Kalibrieren eines Reflektors (704) in einer Solaranlage (604) nach einem der Ansprüche 10 bis 11, wobei das Verfahren aufweist:
Bewegen eines Selektors (710) aus einem Nachführungszustand (713) in einen Kalibrierungszustand (715), um den Kalibrierungsschaltkreis (712) mit dem Satz von Aktuatoren (708) elektrisch zu verbinden;
Umschalten (2200) einer Umschaltvorrichtung (722) aus einem ersten Zustand (732) in einen zweiten Zustand (734); und
Anlegen (2202) einer Kalibrierungsspannung an jeden Aktuator des Satzes von Aktuatoren (708), die dem Reflektor (704) zugeordnet sind, als Antwort auf das Umschalten der Umschaltvorrichtung (722) in den zweiten Zustand (734), wenn ein Kalibrierungsschaltkreis (712) mit dem Satz von Aktuatoren (708) elektrisch verbunden ist.

13. Verfahren nach Anspruch 12, ferner aufweisend:
Halten (2206) der an jedem Aktuator des Satzes von Aktuatoren (708) anliegenden Kalibrierungsspannung nach Umschalten der Umschaltvorrichtung (722) aus dem zweiten Zustand (734) in den ersten Zustand (732).

14. Verfahren nach Anspruch 13, ferner aufweisend:
Umschalten (2204) der Umschaltvorrichtung (722) aus dem zweiten Zustand (734) in den ersten Zustand (732) als Antwort auf ein auftretendes Ereignis (735), wobei das Ereignis (735) ausgewählt ist aus: einem Verstreichen einer vorab gewählten Zeitdauer und einem Empfang eines elektrischen Signals.

15. Verfahren nach Anspruch 12, wobei Anlegen (2202) der Kalibrierungsspannung aufweist:
Anlegen der Kalibrierungsspannung an jeden Aktuator des Satzes von Aktuatoren (708) unter Verwendung einer Energiequelle und eines Satzes von Kondensatoren (736) in dem Kalibrierungsschaltkreis (712),
optional ferner aufweisend:
Halten der Kalibrierungsspannung an jedem Aktuator des Satzes von Aktuatoren (708) unter Verwendung des Satzes von Kondensatoren (736) und eines Satzes von Widerständen (738) in dem Kalibrierungsschaltkreis (712) nach Umschalten der Umschaltvorrichtung (722) aus dem zweiten Zustand (734) in den ersten Zustand (732).

## Revendications

1. Appareil, comprenant :
un ensemble de dispositifs d'actionnement (708) associé à un réflecteur (704) dans un réseau solaire (604) ; et
un sélecteur (710) utilisable pour permuter entre un état de suivi (713) et un état d'étalonnage (715), et
un gestionnaire de tension (714) et un circuit d'étalonnage (712) configurés pour être électriquement connectés/déconnectés à/de l'ensemble de dispositifs d'actionnement (708) en fonction d'un état du sélecteur (710), ledit gestionnaire de tension (714) est configuré pour commander le sélecteur (710) sur la base d'une puissance électrique fournie (622) du réseau solaire (604), de telle sorte que
lorsque le sélecteur (710) est permuté, par le gestionnaire de tension (714), dans l'état de suivi (713), ledit gestionnaire de tension (714) soit configuré pour être connecté à l'ensemble de dispositifs d'actionnement (708) et le circuit d'étalonnage (712) soit configuré pour être déconnecté de l'ensemble de dispositifs d'actionnement (708), dans lequel ledit gestionnaire de tension (714) est configuré pour fournir au moins une portion de la puissance électrique fournie (622) à l'ensemble de dispositifs d'actionnement (708) ; et
lorsque le sélecteur (710) est permuté, par le gestionnaire de tension (714), dans l'état d'étalonnage (715), le circuit d'étalonnage (712) soit configuré pour être électriquement connecté à l'ensemble de dispositifs d'actionnement (708) et le gestionnaire de tension (714) soit configuré pour être déconnecté de l'ensemble de dispositifs d'actionnement (708), dans lequel
le circuit d'étalonnage (712) comprend :
une source d'alimentation électrique (716) ;
un ensemble de condensateurs (718) ;
un ensemble de résistances (720) ; et
un dispositif de permutation (722) utilisable pour permuter entre un premier état (732) et un second état (734),
dans lequel la permutation du dispositif de permutation (722) du premier état (732) au second état (734) fait en sorte que le circuit d'étalonnage (712) applique une tension d'étalonnage à partir de la source d'alimentation électrique (716) sur chacun de l'ensemble de dispositifs d'actionnement (708) lorsque le circuit d'étalonnage (712) est électriquement connecté à l'ensemble de dispositifs d'actionnement (708), et
dans lequel la permutation du dispositif de permutation (722) du second état (734) au premier état (732) fait en sorte que le circuit d'étalonnage (712) arrête de fournir l'alimentation électrique à partir de la source d'alimentation électrique (716).

2. Appareil selon la revendication 1, dans lequel le circuit d'étalonnage (712) maintient la tension d'étalonnage appliquée sur chaque dispositif d'actionnement de l'ensemble de dispositifs d'actionnement (708) après que le dispositif de permutation (722) permute du second état (734) au premier état (732).

3. Appareil selon la revendication 1 ou 2,
dans lequel chacun de l'ensemble de condensateurs (736) se charge lorsque le dispositif de permutation (722) est dans le second état (734) et se décharge après le dispositif de permutation (722) permute du second état (734) au premier état (732).

4. Appareil selon la revendication 3, dans lequel :
la source d'alimentation électrique (716) est configurée pour charger l'ensemble de condensateurs (736) ; et ledit circuit d'étalonnage (712) comprend en outre :
un ensemble de résistances (738) qui commandent un taux de charge et un taux de décharge de l'ensemble de condensateurs (736), optionnellement
dans lequel la source d'alimentation électrique (716) est une source d'alimentation électrique rechargeable (721).

5. Appareil selon la revendication 4, dans lequel la source d'alimentation électrique rechargeable (721) est sélectionnée parmi une batterie rechargeable (726), un banc de condensateurs (728), et un banc d'inducteurs (727).

6. Appareil selon l'une quelconque des revendications 1 à 5,
dans lequel le sélecteur (710) est déplacé de l'état de suivi (713) à l'état d'étalonnage (715) lorsque ladite puissance électrique fournie (622) du réseau solaire (604) est inférieure à une valeur de puissance fournie minimum (717).

7. Appareil selon la revendication 1, dans lequel le réflecteur (704) est un réflecteur à base de systèmes micro-électromécaniques.

8. Appareil selon la revendication 1, dans lequel l'application de la tension d'étalonnage sur chacun de l'ensemble de dispositifs d'actionnement (708) positionne le réflecteur (704) dans une position étalonnée (707).

9. Appareil selon la revendication 8, comprenant en outre :
un substrat (609), dans lequel le réflecteur (704) est couplé au substrat (609) et dans lequel la position étalonnée (707) pour le réflecteur (704) est décalée en rotation par rapport à au moins un axe relativement à un plan du substrat (609).

10. Réseau solaire (604), comprenant :
une pluralité de réflecteurs (702) ;
une pluralité de dispositifs d'actionnement (706) associée à la pluralité de réflecteurs (702) ;
une pluralité de cellules solaires (606) qui génère une puissance électrique fournie (622) ;
un sélecteur (710) utilisable pour permuter entre un état de suivi (713) et un état d'étalonnage (715) ;
un gestionnaire de tension (714) et un circuit d'étalonnage (712) configurés pour être électriquement connectés/déconnectés à/de la pluralité de dispositifs d'actionnement (706) en fonction d'un état du sélecteur (710), ledit gestionnaire de tension (714) est configuré pour commander le sélecteur (710) sur la base de ladite puissance électrique fournie (622), de telle sorte que
lorsque le sélecteur (710) est permuté, par le gestionnaire de tension (714), dans l'état de suivi (713) ledit gestionnaire de tension (714) soit configuré pour être connecté à la pluralité de dispositifs d'actionnement (706) et le circuit d'étalonnage (712) soit configuré pour être déconnecté de la pluralité de dispositifs d'actionnement (706), dans lequel ledit gestionnaire de tension (714) est configuré pour fournir au moins une portion de la puissance électrique fournie (622) à la pluralité de dispositifs d'actionnement (706) ; et
lorsque le sélecteur (710) est permuté, par le gestionnaire de tension (714), dans l'état d'étalonnage (715), le circuit d'étalonnage (712) soit configuré pour être électriquement connecté à la pluralité de dispositifs d'actionnement (706) et le gestionnaire de tension (714) soit configuré pour être déconnecté de la pluralité de dispositifs d'actionnement (706), dans lequel
le circuit d'étalonnage (712) comprend :
une source d'alimentation électrique (716) ;
une pluralité de condensateurs (718) ;
une pluralité de résistances (720) ; et
un dispositif de permutation (722) utilisable pour permuter entre un premier état (732) et un second état (734),
dans lequel la permutation du dispositif de permutation (722) du premier état (732) au second état (734) fait en sorte que le circuit d'étalonnage (712) applique une tension d'étalonnage à partir de la source d'alimentation électrique (716) sur chacun de la pluralité de dispositifs d'actionnement (706) lorsque le circuit d'étalonnage (712) est électriquement connecté à la pluralité de dispositifs d'actionnement (706) ; et
dans lequel la permutation du dispositif de permutation (722) du second état (734) au premier état (732) fait en sorte que le circuit d'étalonnage (712) arrête de fournir l'alimentation électrique à partir de la source d'alimentation électrique (716).

11. Réseau solaire (604) selon la revendication 10, dans lequel le circuit d'étalonnage (712) maintient la tension d'étalonnage appliquée sur chaque dispositif d'actionnement de la pluralité de dispositifs d'actionnement (706) après que le dispositif de permutation (722) permute du second état (734) au premier état (732),
dans lequel chacun de la pluralité de condensateurs (718) se charge lorsque le dispositif de permutation (722) est dans le second état (734) et se décharge après que le dispositif de permutation (722) permute du second état (734) au premier état (732).

12. Procédé pour étalonner un réflecteur (704) dans un réseau solaire (604) selon l'une quelconque des revendications 10 et 11, le procédé comprenant :
le déplacement d'un sélecteur (710) d'un état de suivi (713) à un état d'étalonnage (715) pour électriquement connecter le circuit d'étalonnage (712) à l'ensemble de dispositifs d'actionnement (708) ;
la permutation (2200) d'un dispositif de permutation (722) d'un premier état (732) à un second état (734) ; et
l'application (2202) d'une tension d'étalonnage sur chacun d'un ensemble de dispositifs d'actionnement (708) associé au réflecteur (704) en réponse au fait que le dispositif de permutation (722) permute au second état (734) lorsqu'un circuit d'étalonnage (712) est électriquement connecté à l'ensemble de dispositifs d'actionnement (708).

13. Procédé selon la revendication 12, comprenant en outre :
le maintien (2206) de la tension d'étalonnage appliquée sur chaque dispositif d'actionnement de l'ensemble de dispositifs d'actionnement (708) après que le dispositif de permutation (722) permute du second état (734) au premier état (732).

14. Procédé selon la revendication 13, comprenant en outre :
la permutation (2204) du dispositif de permutation (722) du second état (734) au premier état (732) en réponse au fait qu'un événement (735) se produit, dans lequel l'événement (735) est un sélectionné parmi une expiration d'une période présélectionnée et une réception d'un signal électrique.

15. Procédé selon la revendication 12, dans lequel l'application (2202) de la tension d'étalonnage comprend :
l'application de la tension d'étalonnage sur chaque dispositif d'actionnement de l'ensemble de dispositifs d'actionnement (708) en utilisant une source d'alimentation électrique et un ensemble de condensateurs (736) dans le circuit d'étalonnage (712), comprenant optionnellement en outre :
le maintien de la tension d'étalonnage au niveau de chaque dispositif d'actionnement de l'ensemble de dispositifs d'actionnement (708) en utilisant l'ensemble de condensateurs (736) et un ensemble de résistances (738) dans le circuit d'étalonnage (712) après que le dispositif de permutation (722) permute du second état (734) au premier état (732).
